# EUROPEAN PATENT APPLICATION

(11) **EP 4 719 017 A1**
(43) Date of publication of application: **01.04.2026**
(21) Application number: 25204762.6
(22) Date of filing: 25.09.2025
(51) Int. Cl.: H10K 59/80

(54) **DISPLAY PANEL AND ELECTRONIC APPARATUS INCLUDING THE SAME**

(30) Priority: 26.09.2024 KR 20240131094
(71) Applicant: Samsung Display Co., Ltd., Yongin-si, Gyeonggi-do 17113 (KR)
(72) Inventor: Oh, Yuri, 17113 Yongin-si, Gyeonggi-do (KR); Lee, Jongchan, 17113 Yongin-si, Gyeonggi-do (KR); Shin, Jonghwan, 17113 Yongin-si, Gyeonggi-do (KR); Yang, Yongho, 17113 Yongin-si, Gyeonggi-do (KR); Yoo, Kibok, 17113 Yongin-si, Gyeonggi-do (KR); Lee, Donghyeok, 17113 Yongin-si, Gyeonggi-do (KR); Jeong, Kitaek, 17113 Yongin-si, Gyeonggi-do (KR); Jo, Yongseon, 17113 Yongin-si, Gyeonggi-do (KR)
(74) Representative: Gulde & Partner

(57) **Abstract**

A display panel (10) includes a substrate (100) having an opening (100OP), an inorganic insulation structure (IL) on the substrate (100), light-emitting diodes (LED) defining a display area (DA) extending around the opening (100OP), an encapsulation layer (300) on the light-emitting diodes (LED), a trench (TCH) in the inorganic insulation structure (IL) in a non-display area (PA) between the opening (100OP) in the substrate (100) and the display area (DA), an insulating layer (1100) on one edge portion of the trench (TCH) and having a groove (G) defined therein, and first and second metal layers (1200) spaced apart from each other on the insulating layer (1100). The first and second metal layers (1200) respectively have first and second overhang portions (P) extending toward the groove (G), at least one of the light-emitting diodes (LED) includes a pixel electrode (221), an opposite electrode (223) on the pixel electrode (221), and an intermediate layer (222), and an organic layer (222b) of the intermediate layer (222) is separated into a plurality of portions by the first and second overhang portions (P).

## Description

### BACKGROUND

### 1. Field

Aspects of embodiments of the present disclosure relate to a display panel and an electronic apparatus including the same.

### 2. Description of the Related Art

Recently, the usage of display devices has diversified. In addition, as display devices have become thinner and lighter, the range of usage thereof is increasing.

As the area that a display area occupies within display devices increases, various functions connected or linked to display devices are being added. As a way of expanding the area while also adding various functions, a display panel in which various components may be arranged in a display area is being researched.

### SUMMARY

Embodiments of the present disclosure include a display panel having an opening area in which various types of components may be arranged and a display device including the display panel. However, the above aspects and features are one example, and the scope of the present disclosure is not limited thereto.

Additional aspects and features will be set forth, in part, in the description which follows and, in part, will be apparent from the description or may be learned by practice of the described embodiments.

According to an embodiment of the present disclosure, a display panel includes a substrate having an upper surface and a lower surface opposite to the upper surface and an opening passing from the upper surface to the lower surface, an inorganic insulation structure including a plurality of inorganic insulating layers on the upper surface of the substrate, a plurality of light-emitting diodes on an upper surface of the inorganic insulation structure and defining a display area extending around a periphery of the opening, an encapsulation layer on the plurality of light-emitting diodes and including an inorganic encapsulation layer and an organic encapsulation layer, a trench in the inorganic insulation structure in a non-display area between the opening in the substrate and the display area, an insulating layer on one edge portion of the trench and having a groove defined therein, and a first metal layer and a second metal layer spaced apart from each other on the insulating layer. The first metal layer has a first overhang portion extending toward the groove from a point at where a lower surface of the first metal layer and an inner surface of the insulating layer defining the groove meet each other, and the first overhang portion overlaps the trench. The second metal layer has a second overhang portion extending toward the groove from a point at where a lower surface of the second metal layer and the inner surface of the insulating layer defining the groove meet each other. At least one of the plurality of light-emitting diodes includes a pixel electrode, an opposite electrode on the pixel electrode, and an intermediate layer between the pixel electrode and the opposite electrode, and an organic layer of the intermediate layer is separated into a plurality of portions by the first overhang portion and the second overhang portion.

The trench may have a first edge portion adjacent to the opening in the substrate and may have a second edge portion opposite the first edge portion, and the insulating layer may overlap the second edge portion.

The insulating layer may include an organic insulating material.

An upper surface of the first overhang portion may be substantially parallel to a virtual plane parallel to the substrate or may be tilted downwardly.

A portion of the first metal layer on an opposite side to the first overhang portion may be in direct contact with a bottom surface of the trench, and a portion of the second metal layer may be in direct contact with the upper surface of the inorganic insulation structure.

The display panel may further include a protective layer on the first overhang portion of the first metal layer.

The protective layer may be on an upper surface and a side surface of the first overhang portion.

The display panel may further include a protective material layer on a bottom surface of the groove, and the protective material layer may include a same material as the protective layer.

The protective layer may include a same material as the pixel electrode.

The protective layer may extend over a bottom surface of the trench and may be in direct contact with the bottom surface of the trench.

The display panel may further include a partition wall in the non-display area and extending around a periphery of the opening in the substrate, and the partition wall may be between the trench and the display area.

The display panel may further include a first insulating layer between the trench and the display area and spaced apart from the insulating layer and may further include a pair of metal layers on the first insulating layer, each may have an overhang portion. The overhang portion may hang over the groove in the first insulating layer from a point at where a lower surface of a corresponding metal layer from among the pair of metal layers and an inner surface of the first insulating layer defining the groove meet each other.

One of the pair of metal layers may include a portion opposite to the overhang portion of the one of the metal layers, and a portion of the one of the metal layers may overlap the partition wall.

The display panel may further include an additional protective layer on the overhang portion of the one of the metal layers.

The additional protective layer may extend over an upper surface of the portion of the one of the metal layers and may overlap the partition wall.

According to an embodiment of the present disclosure, an electronic apparatus includes a display panel as described above and a component overlapping the opening area of the display panel. The display panel may include an opening area and a display area extending around a periphery of the opening area.

The component may include a camera or a sensor.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

The above and other aspects and features of embodiments of the present disclosure will be more apparent from the following description, taken in conjunction with the accompanying drawings, in which:
FIG. 1 is a perspective view schematically illustrating an electronic apparatus according to an embodiment;
FIG. 2 is a schematic cross-sectional view taken along the line I-I' in FIG. 1;
FIG. 3 is a schematic plan view of a display panel according to an embodiment;
FIG. 4A is an equivalent circuit diagram schematically illustrating a light-emitting diode and a circuit connected to the light-emitting diode according to an embodiment;
FIG. 4B is an equivalent circuit diagram schematically illustrating a light-emitting diode and a circuit connected to the light-emitting diode according to an embodiment;
FIG. 5 is a plan view of a portion of a display panel according to an embodiment;
FIG. 6 is a cross-sectional view taken along the line VI-VI' in FIG. 5;
FIG. 7 is a cross-sectional view taken along the line VII-VII' in FIG. 5;
FIG. 8 is a cross-sectional view of a portion of a display panel corresponding to the region VIII in FIG. 7 according to an embodiment;
FIG. 9 is a cross-sectional view of a portion of a display panel corresponding to the region VIII in FIG. 7 according to another embodiment;
FIG. 10A is a cross-sectional view of a portion of a display panel corresponding to the region X in FIG. 8 according to an embodiment;
FIG. 10B is a cross-sectional view of a portion of a display panel corresponding to the region X in FIG. 8 according to another embodiment;
FIG. 11 is a cross-sectional view of a portion of a display panel corresponding to the region XI in FIG. 7 according to an embodiment;
FIG. 12 is a cross-sectional view of a portion of a display panel corresponding to the region XI in FIG. 7 according to another embodiment;
FIG. 13 is a cross-sectional view of a portion of a display panel corresponding to the region XIII in FIG. 7 according to an embodiment;
FIG. 14 is a cross-sectional view of a portion of a display panel corresponding to the region XIII in FIG. 7 according to another embodiment;
FIG. 15 is a cross-sectional view of a portion of a display panel corresponding to the region XIII in FIG. 7 according to another embodiment;
FIGS. 16A to 16G are cross-sectional views of an inner non-display area illustrating steps of a manufacturing process of a display panel according to an embodiment; and
FIG. 17 is a cross-sectional view of a portion of a display panel according to another embodiment.

### DETAILED DESCRIPTION

Reference will now be made, in detail, to embodiments, examples of which are illustrated in the accompanying drawings. In this regard, the described embodiments may have different forms and should not be construed as being limited to the descriptions set forth herein. Accordingly, embodiments are merely described below, by referring to the figures, to explain aspects and features of the present description.

As the present disclosure allows for various changes and numerous embodiments, example embodiments will be illustrated in the drawings and described in detail in the written description. The aspects and features of the present disclosure, and ways to achieve them, will become apparent by referring to embodiments that will be described later, in detail, with reference to the drawings. However, the present disclosure is not limited to the following embodiments but may be embodied in various forms.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. For example, the expression "at least one of a, b, or c" indicates only a, only b, only c, both a and b, both a and c, both b and c, all of a, b, and c, or variations thereof. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of 35 U.S.C. § 112(a) and 35 U.S.C. § 132(a).

When an embodiment may be implemented in another manner, a process order may be different from a described order. For example, two processes that are consecutively described may be performed concurrently or substantially simultaneously or may be performed in an opposite order to the described order.

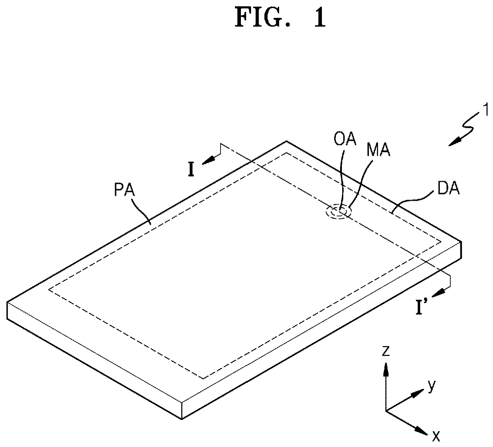

FIG. 1 is a perspective view schematically illustrating an electronic apparatus 1 according to an embodiment.

Referring to FIG. 1, the electronic apparatus 1 may include a device that displays (e.g., is configured to display) moving images or still images and may be used as a display screen for portable electronic apparatuses, such as mobile phones, smart phones, tablet personal computers (PCs), mobile communication terminals, electronic notebooks, e-books, portable multimedia players (PMPs), navigation devices, and ultra-mobile PCs (UMPCs), and also for various products, such as televisions, laptop computers, monitors, billboards, and Internet of Things (IoT) devices. In addition, the electronic apparatus 1, according to an embodiment, may be used in a wearable device, such as a smart watch, a watch phone, a glasses-type display, and a head mounted display (HMD). Furthermore, the electronic apparatus 1, according an embodiment, may be used as a center information display (CID) arranged on (or in) an instrument panel of a vehicle, a center fascia, or a dashboard of a vehicle, a room mirror display functioning in place of a side mirror of a vehicle, as a display arranged on the back of a front seat as an entertaining element for a rear seat of a vehicle. For convenience of description, the embodiment illustrated in FIG. 1 is a smart phone.

The electronic apparatus 1 may have a rectangular shape in a plan view. For example, the electronic apparatus 1 may have a rectangular planar shape having a short side in an x-direction and a long side in a y-direction, as illustrated in, for example, FIG. 1. A corner at where the short side of the electronic apparatus 1 in the x-direction and the long side of the electronic apparatus 1 in the y-direction meet each other may be rounded to have a curvature (e.g., a certain curvature) or formed at a right angle. The flat shape of the electronic apparatus 1 is not limited to a rectangle and may be have other polygonal, elliptical, or irregular shapes.

The electronic apparatus 1 may have an opening area (e.g., a first area or first open area) OA and a display area (e.g., a second area) DA at least partially surrounding (e.g., extending at least partially around a periphery of) the opening area OA. The electronic apparatus 1 may have a non-display area (e.g., a third area) MA adjacent to the opening area OA and located in the display area DA (hereinafter referred to as an "inner non-display area MA") and a non-display area (e.g., a fourth area) PA outside the display area DA (hereinafter referred to as an "outer non-display area PA"). The inner non-display area MA may have a closed loop shape that entirely surrounds (e.g., extends entirely around a periphery of) the opening area OA on a plane (e.g., in a plan view) and may be entirely surrounded by the display area DA. The outer non-display area PA may completely surround the display area DA on a plane (e.g., in a plan view). in this specification, the phrase "on a plane" or "plan view" may refer to viewing a target portion from the top or may refer to "when viewed in a direction perpendicular to a top surface of the substrate," and the phrase "cross-sectional view" refers to viewing a cross-section formed by vertically cutting a target portion from the side.

The opening area OA may be located in the display area DA. In an embodiment, the opening area OA may be positioned in an upper center portion of the display area DA as illustrated in, for example, FIG. 1. However, the opening area OA may be positioned in various manners or locations, for example, at the upper left side of the display area DA or at the upper right side of the display area DA. The embodiment illustrated in FIG. 1 has one opening area OA, but in another embodiment, a plurality of opening areas OA may be included.

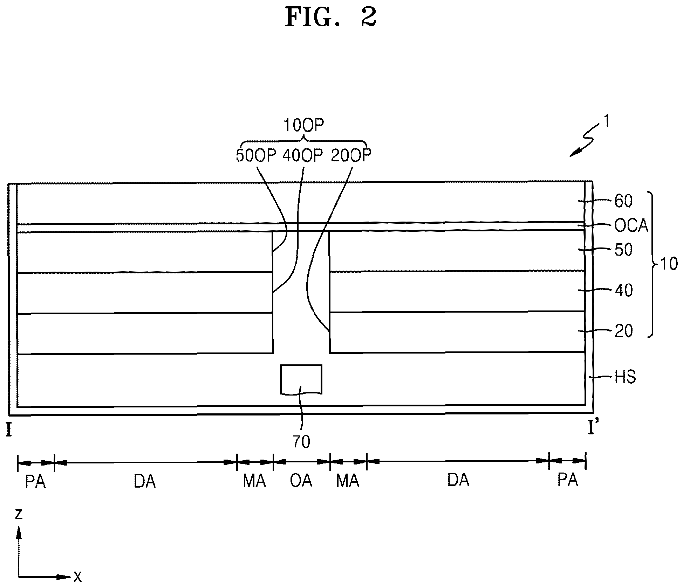

FIG. 2 is a cross-sectional view schematically illustrating the electronic apparatus 1 according to an embodiment and is a cross-sectional view taken along the line I-I' in FIG. 1.

Referring to FIG. 2, the electronic apparatus 1 may include a display panel 10 and a component 70 positioned in the opening area OA of the display panel 10. The component 70 may be below the display panel 10. The display panel 10 and the component 70 may be accommodated in a housing HS.

The display panel 10 may include an image generation layer 20, an input sensing layer 40, an optical functional layer 50, and a cover window 60.

The image generation layer 20 may include display elements (e.g., light-emitting elements) that emit light to display an image. The display element may include a light-emitting diode, for example, an organic light-emitting diode including an organic emission layer. In another embodiment, the light-emitting diode may be an inorganic light-emitting diode including an inorganic material. The inorganic light-emitting diode may include a PN junction diode including inorganic semiconductor-based materials. When a voltage is applied to the PN junction diode in a forward direction, holes and electrons are injected, and energy generated by recombination of the holes and electrons is converted into light energy to emit light of a certain color. The inorganic light-emitting diode may have a width in a range of several to several hundreds of micrometers or several to several hundreds of nanometers. In some embodiments, the image generation layer 20 may include a quantum dot light-emitting diode. For example, an emission layer of the image generation layer 20 may include an organic material, an inorganic material, quantum dots, an organic material and quantum dots, or an inorganic material and quantum dots.

The input sensing layer 40 may obtain coordinate information according to an external input, such as a touch event. The input sensing layer 40 may include sensing electrodes or touch electrodes and signal lines (e.g., trace lines) connected to the sensing electrodes or touch electrodes. The input sensing layer 40 may be arranged on the image generation layer 20. The input sensing layer 40 may detect an external input by using a mutual cap method or/and a self cap method.

The input sensing layer 40 may be formed directly on the image generation layer 20 or may be formed separately and then bonded to the image generation layer 20 through an adhesive layer, such as an optically transparent adhesive. For example, the input sensing layer 40 may be formed continuously after a process of forming the image generation layer 20, in which case the adhesive layer may not be between the input sensing layer 40 and the image generation layer 20. Although FIG. 2 illustrates an embodiment in which the input sensing layer 40 is between the image generation layer 20 and the optical functional layer 50, in another embodiment, the input sensing layer 40 may be arranged on the optical functional layer 50.

The optical functional layer 50 may include an anti-reflection layer. The anti-reflection layer may reduce reflectivity of light (e.g., external light) incident from the outside toward the display panel 10 through the cover window 60. The anti-reflection layer may include a retarder and a polarizer. In some embodiments, the anti-reflection layer may include a black matrix and color filters. The color filters may be arranged in consideration of the color of light emitted from each of the light-emitting diodes of the image generation layer 20.

To improve transmittance of the opening area OA, the display panel 10 may have an opening 10OP penetrating (e.g., extending through) some of the layers constituting the display panel 10. The opening 10OP may include first to third openings 20OP, 40OP, and 50OP that penetrate (e.g., extend through) the image generation layer 20, the input sensing layer 40, and the optical functional layer 50, respectively. The first opening 20OP in the image generation layer 20, the second opening 40OP in the input sensing layer 40, and the third opening 50OP in the optical functional layer 50 may overlap each other (e.g., may be aligned with each other) to form the opening 10OP in the display panel 10.

The cover window 60 may be arranged on the optical functional layer 50. The cover window 60 may be bonded to the optical functional layer 50 through an adhesive layer, such as a transparent optical clear adhesive (OCA). The cover window 60 may cover the first opening 20OP in the image generation layer 20, the second opening 40OP in the input sensing layer 40, and the third opening 50OP in the optical functional layer 50.

The cover window 60 may include glass or a plastic material. The glass material may include ultra-thin glass. The plastic material may include polyethersulfone, polyacrylate, polyether imide, polyethylene naphthalate, polyethylene terephthalate, polyphenylene sulfide, polyarylate, polyimide, polycarbonate, or cellulose acetate propionate.

The opening area OA may be a type of component area (e.g., a sensor area, a camera area, a speaker area, etc.) at where the component 70 for adding various functions to the electronic apparatus 1 is located.

The component 70 may include an electronic element. For example, the component 70 may be an electronic element that utilizes (e.g., receives and/or outputs) light or sound. For example, the electronic element may include sensors that utilize light, such as infrared sensors, cameras that receive light and capture images, sensors that output and detect light or sound to measure distances or recognize fingerprints, small lamps that output light, or speakers that output sound. The electronic element that utilizes light may utilize light of various wavelengths, such as visible light, infrared light, and/or ultraviolet light. The opening area OA corresponds to a region through which light or/and sound output from the component 70 to the outside or traveling from the outside toward the electronic element may pass.

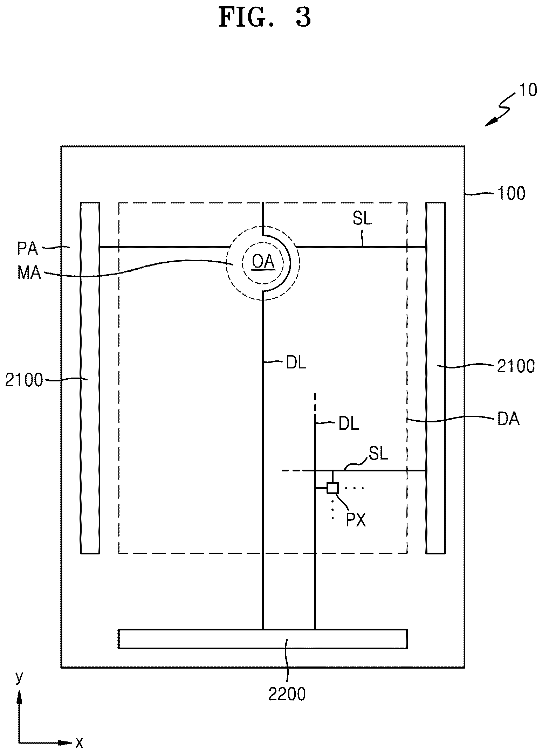

FIG. 3 is a schematic plan view of a display panel 10 according to an embodiment.

Referring to FIG. 3, the display panel 10 may have the opening area OA, the display area DA, the inner non-display area MA, and the outer non-display area PA.

The display panel 10 may include a plurality of pixels PX arranged in the display area DA, and the display panel 10 may display an image by using light emitted from each pixel PX. Each pixel PX may emit red, green, or blue light by using a light-emitting diode. The light-emitting diode of each pixel PX may be electrically connected to a scan line SL and a data line DL.

In the outer non-display area PA, a scan driver 2100 that provides (e.g., outputs) a scan signal to each pixel PX, a data driver 2200 that provides (e.g., outputs) a data signal to each pixel PX, and a first main power line and a second main power line that provide a first power voltage and a second power voltage, respectively, may be arranged. The scan driver 2100 may be arranged on each opposite side of the display area DA. In such an embodiment, the pixel PX positioned on the left with respect to the opening area OA may be connected to the scan driver 2100 positioned on the left, and the pixel PX positioned on the right with respect to the opening area OA may be connected to the scan driver 2100 positioned on the right.

The inner non-display area MA may surround the opening area OA. The inner non-display area MA is an area where no display elements, such as light-emitting diodes that emit light, are arranged, but signal lines that provide signals to the pixels PX provided around the opening area OA may pass through the inner non-display area MA. For example, data lines DL and/or scan lines SL may pass across the display area DA, but portions of the data lines DL and/or the scan lines SL may pass through the inner non-display area MA along an edge of an opening 10OP in the display panel 10 formed in the opening area OA. The embodiment illustrated in FIG. 3 includes the data lines DL passing across the display area DA in the y-direction, but some of the data lines DL bypass to partially surround the opening area OA in the inner non-display area MA. The scan lines SL may pass across the display area DA in the x-direction and may be spaced apart from each other with the opening area OA therebetween.

FIG. 3 illustrates an embodiment in which the data driver 2200 is positioned adjacent to one side of the substrate 100, but according to another embodiment, the data driver 2200 may be positioned on a printed circuit board electrically connected to a pad positioned at one side of the display panel 10. The printed circuit board may be flexible, and a portion of the printed circuit board may be bent to be positioned below a back surface of the substrate 100.

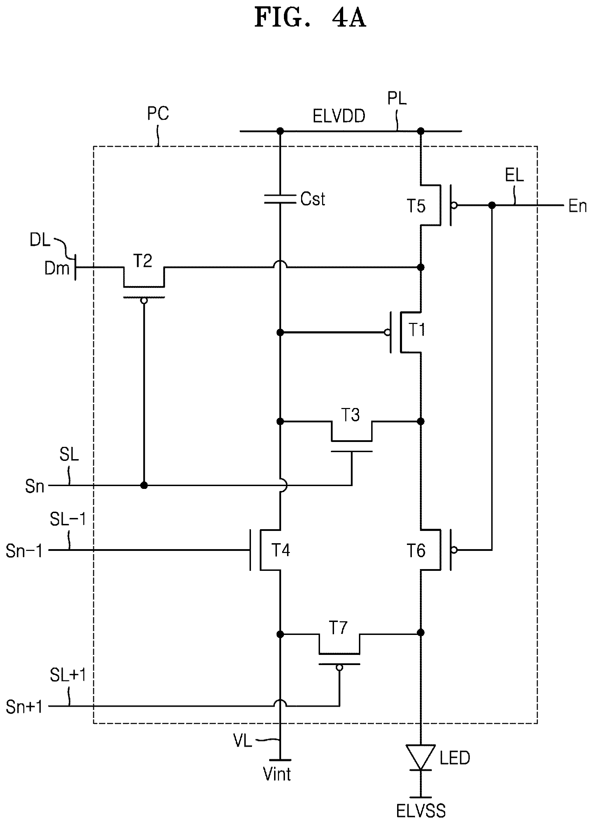

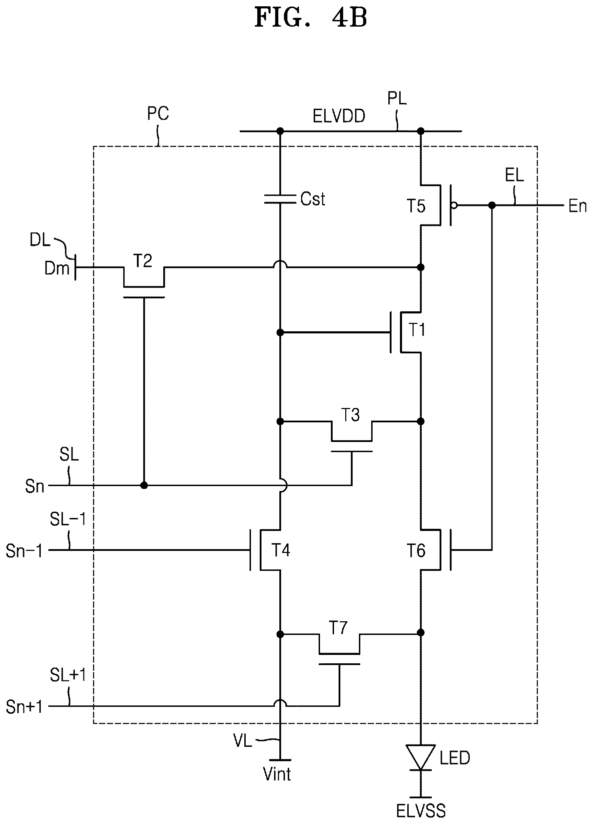

FIGS. 4A and 4B are each an equivalent circuit diagram schematically illustrating a light-emitting diode LED and a pixel circuit PC connected to the light-emitting diode LED according to an embodiment.

Referring to FIGS. 4A and 4B, the pixel PX, described with reference to FIG. 3 as an example, may emit light through a light-emitting diode LED, and the light-emitting diode LED may be electrically connected to a pixel circuit PC.

The pixel circuit PC may include a first thin-film transistor T1, a second thin-film transistor T2, a third thin-film transistor T3, a fourth thin-film transistor T4, a fifth thin-film transistor T5, a sixth thin-film transistor T6, a seventh thin-film transistor T7, and a storage capacitor Cst.

Some of the first to seventh thin-film transistors T1, T2, T3, T4, T5, T6, and T7 may include n-channel metal oxide semiconductor field-effect transistors (MOSFETs) (NMOSs), and the rest may include p-channel MOSFETs (PMOSs). In an embodiment, as illustrated in FIG. 4A, from among the first to seventh thin-film transistors T1, T2, T3, T4, T5, T6, and T7, the third thin-film transistor T3 and the fourth thin-film transistor T4 may be NMOSs, and the rest may be PMOSs. In another embodiment, as illustrated in FIG. 4B, from among the first to seventh thin-film transistors T1, T2, T3, T4, T5, T6, and T7 , the fifth thin-film transistor T5 may be a PMOS, and the rest may be NMOSs.

At least one of the first to seventh thin-film transistors T1, T2, T3, T4, T5, T6, or T7 may be a transistor having a low-temperature polycrystalline silicon (LTPS) semiconductor layer, and at least one of the first to seventh thin-film transistors T1, T2, T3, T4, T5, T6, or T7 may be a transistor having an oxide semiconductor layer. In an embodiment, as illustrated in FIG. 4A, the third thin-film transistor T3 and the fourth thin-film transistor T4 may include an oxide semiconductor layer having low leakage current, and the first, second, fifth, sixth, and seventh thin-film transistors T1, T2, T5, T6, and T7 may include a semiconductor layer including polycrystalline silicon. In another embodiment, as illustrated in FIG. 4B, the fifth thin-film transistor T5 may include a semiconductor layer including polycrystalline silicon, and the first, second, third, fourth, sixth, and seventh thin-film transistors T1, T2, T3, T4, T6, and T7 may include an oxide semiconductor layer.

The second thin-film transistor T2 may include a data writing thin-film transistor, which is connected to the scan line SL and the data line DL, and may be configured to transmit a data voltage (e.g., a data signal Dm) input from the data line DL to the first thin-film transistor T1 based on a switching voltage (e.g., a switching signal Sn) input from the scan line SL. The storage capacitor Cst may be connected to the first thin-film transistor T1 and a driving voltage line PL and may store a voltage corresponding to a difference between a voltage received from the second thin-film transistor T2 and a first power voltage ELVDD supplied to the driving voltage line PL.

The first thin-film transistor T1 may include a driving thin-film transistor, may be connected to the driving voltage line PL and the storage capacitor Cst, and may control a driving current flowing from the driving voltage line PL through the light-emitting diode LED in response to a voltage value stored in the storage capacitor Cst. The light-emitting diode LED may emit light having a luminance according to the driving current. A second electrode (e.g., a cathode) of the light-emitting diode LED may receive a common voltage ELVSS.

The third thin-film transistor T3 may include a compensation thin-film transistor, and a gate electrode of the third thin-film transistor T3 may be connected to the scan line SL. A source electrode (or drain electrode) of the third thin-film transistor T3 may be connected to a drain electrode (or source electrode) of the first thin-film transistor T1 and may be connected to a first electrode of the light-emitting diode LED via the sixth thin-film transistor T6. The drain electrode (or source electrode) of the third thin-film transistor T3 may be connected to one electrode of the storage capacitor Cst, a source electrode (or drain electrode) of the fourth thin-film transistor T4, and a gate electrode of the first thin-film transistor T1. The third thin-film transistor T3 may be turned on according to a scan signal Sn received through the scan line SL to connect the gate electrode and the drain electrode of the first thin-film transistor T1 to each other, thereby diode-connecting the first thin-film transistor T1.

As an initialization thin-film transistor, a gate electrode of the fourth thin-film transistor T4 may be connected to a previous scan line SL-1. The drain electrode (or source electrode) of the fourth thin-film transistor T4 may be connected to an initialization voltage line VL. The source electrode (or drain electrode) of the fourth thin-film transistor T4 may be connected to one electrode of the storage capacitor Cst, the drain electrode (or source electrode) of the third thin-film transistor T3, and the gate electrode of the first thin-film transistor T1. The fourth thin-film transistor T4 may be turned on according to a previous scan signal Sn-1 received through the previous scan line SL-1 to perform an initialization operation of initializing a voltage of the gate electrode of the first thin-film transistor T1 by transferring the initialization voltage Vint to the gate electrode of the first thin-film transistor T1.

The fifth thin-film transistor T5 may include an operation control thin-film transistor, and a gate electrode thereof may be connected to an emission control line EL. A source electrode (or drain electrode) of the fifth thin-film transistor T5 may be connected to the driving voltage line PL. The drain electrode (or source electrode) of the fifth thin-film transistor T5 may be connected to the source electrode (or drain electrode) of the first thin-film transistor T1 and the drain electrode (or source electrode) of the second thin-film transistor T2.

The sixth thin-film transistor T6 may include an emission control thin-film transistor, and a gate electrode thereof may be connected to the emission control line EL. A source electrode (or drain electrode) of the sixth thin-film transistor T6 may be connected to the drain electrode (or source electrode) of the first thin-film transistor T1 and the source electrode (or drain electrode) of the third thin-film transistor T3. The drain electrode (or source electrode) of the sixth thin-film transistor T6 may be electrically connected to the first electrode of the light-emitting diode LED. The fifth thin-film transistor T5 and the sixth thin-film transistor T6 may be concurrently (or simultaneously) turned on according to an emission control signal En received through the emission control line EL to transmit the driving voltage ELVDD to the light-emitting diode LED such that a driving current flows to the light-emitting diode.

The seventh thin-film transistor T7 may be an initialization thin-film transistor that initializes the first electrode of the light-emitting diode LED. A gate electrode of the seventh thin-film transistor T7 may be connected to a next scan line SL+1. A source electrode (or drain electrode) of the seventh thin-film transistor T7 may be connected to the first electrode of the light-emitting diode LED. The drain electrode (or source electrode) of the seventh thin-film transistor T7 may be connected to the initialization voltage line VL. The seventh thin-film transistor T7 may be turned on according to the next scan signal Sn+1 received through the next scan line SL+1 to initialize the first electrode of the light-emitting diode LED.

In FIGS. 4A and 4B, the fourth thin-film transistor T4 and the seventh thin-film transistor T7 are respectively connected to the previous scan line SL-1 and the subsequent scan line SL+1. However, in another embodiment, the fourth thin-film transistor T4 and the seventh thin-film transistor T7 may both be connected to the previous scan line SL-1 and driven according to the previous scan signal Sn-1.

Another electrode of the storage capacitor Cst may be connected to the driving voltage line PL. Any one electrode of the storage capacitor Cst may be connected together to the gate electrode of the first thin-film transistor T1, the drain electrode (or source electrode) of the third thin-film transistor T3, and the source electrode (or drain electrode) of the fourth thin-film transistor T4.

The second electrode (e.g., cathode) of the light-emitting diode LED is supplied with the common voltage ELVSS. The light-emitting diode LED receives a driving current from the first thin-film transistor T1 to emit light.

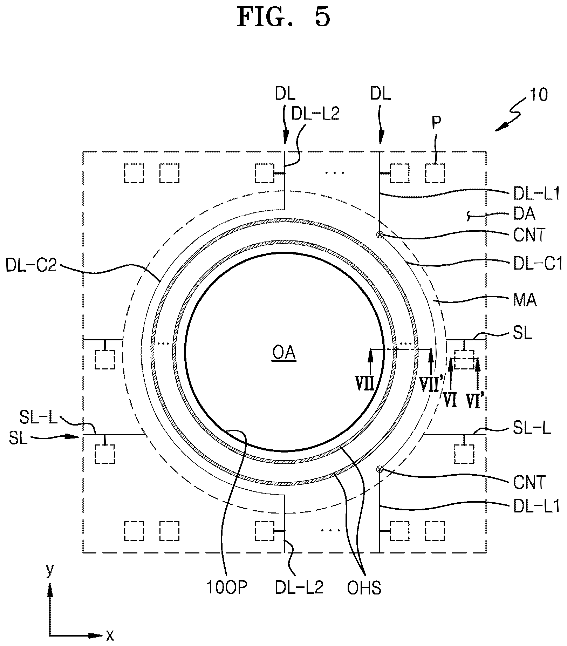

FIG. 5 is a plan view of a portion of the display panel 10 according to an embodiment.

Referring to FIG. 5, the pixels PX are arranged in the display area DA. The inner non-display area MA may be located between the opening area OA and the display area DA. The pixels PX adjacent to the opening area OA may be arranged on a plane to be spaced apart from each other with the opening area OA as a center. On the plane shown in FIG. 5, the pixels PX may be arranged vertically apart from each other with the opening area OA as a center or may be spaced apart from each other on the left and right with the opening area OA as a center. Because each pixel PX emit red, green, and blue light emitted from a light-emitting diode, positions of the pixels PX illustrated in FIG. 5 correspond to positions of light-emitting diodes, respectively. Therefore, the pixels PX arranged on a plane and spaced apart from each other with the opening area OA as a center may indicate that light-emitting diodes are arranged on a plane and spaced apart from each other with the opening area OA as a center. For example, on a plane, the light-emitting diodes may be arranged vertically apart from each other with the opening area OA as a center or may be spaced apart from each other on the left and right with the opening area OA as a center.

From among signal lines configured to supply signals to the pixel circuit PC connected to the light-emitting diode of each pixel PX, signal lines adjacent to the opening area OA may bypass the opening area OA and/or the opening 10OP. Some of the data lines DL passing through the display area DA may extend in a ±y-direction to provide data signals to the pixels PX positioned above and below the opening area OA, respectively, and may bypass (e.g., may curve) along the edge of the opening area OA and/or the opening 10OP in the inner non-display area MA.

From among the data lines DL, a bypass portion DL-C1 of at least one data line DL may be formed on a different layer from an extension portion DL-L1 crossing the display area DA, and the bypass portion DL-C1 and the extension portion DL-L1 of the data line DL may be connected to each other through a contact hole (e.g., a contact opening) CNT. From among the data lines DL, a bypass portion DL-C2 of at least one data line DL is located on a same layer as an extension portion DL-L2 and may be formed as a single body with (e.g., may be integrally formed with) the extension portion DL-L2.

The scan lines SL may be separated or disconnected with respect to the opening area OA, and as described above with reference to FIG. 3, the scan lines SL arranged on the left with respect to the opening area OA may receive signals from the scan driver 2100 arranged on the left with respect to the display area DA and the scan lines SL arranged on the right with respect to the opening area OA may receive signals from the scan driver 2100 arranged on the right with respect to the display area DA, as illustrated in FIG. 3.

Overhang structures OHS may be positioned between a region of the inner non-display area MA, through which the data lines DL bypass, and the opening area OA. On a plane, the overhang structures OHS may each have a closed loop shape surrounding (e.g., extending around) the opening area OA, and the overhang structures OHS may be spaced apart from each other.

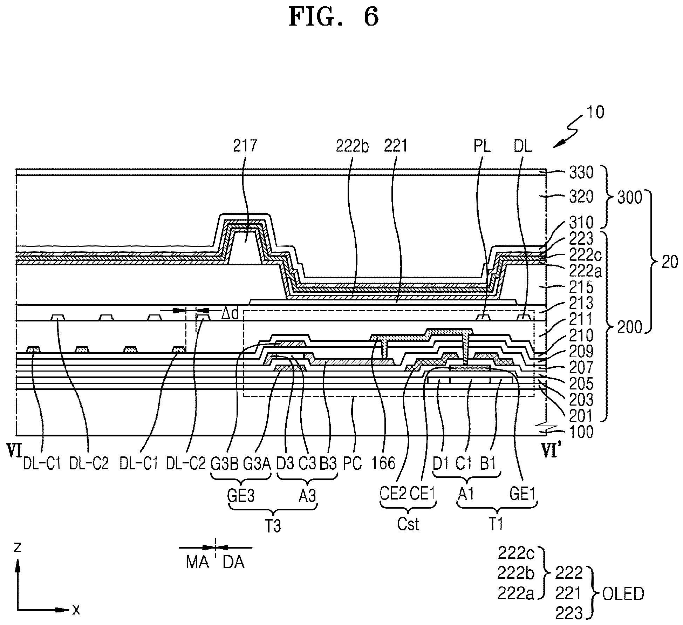

FIG. 6 is a cross-sectional view of the display panel 10 according to an embodiment, taken along the line VI-VI' in FIG. 5. FIG. 6 illustrates one light emitting diode LED (hereinafter, referred to as a first light emitting diode) among a plurality of light emitting diodes LED arranged in the display area DA, and data lines DL located in the inner non-display area MA.

Referring to the display area DA shown in FIG. 6, the substrate 100 may include a glass material or a polymer resin. In an embodiment, the substrate 100 may have an alternating stack structure of a base layer including a polymer resin and a barrier layer including an inorganic insulating material, such as silicon oxide or silicon nitride. The polymer resin may include a polymer resin, such as polyethersulfone, polyarylate, polyether imide, polyethylene naphthalate, polyethylene terephthalate, polyphenylene sulfide, polyimide, polycarbonate, cellulose triacetate, cellulose acetate propionate, and the like.

The pixel circuit PC may be formed on the substrate 100, and a light-emitting diode, such as an organic light-emitting diode OLED, may be arranged on the pixel circuit PC.

Before the pixel circuit PC is formed, a buffer layer 201 may be formed on the substrate 100 to prevent impurities from penetrating into the pixel circuit PC. The buffer layer 201 may include an inorganic insulating material, such as silicon nitride, silicon oxynitride, and silicon oxide, and may have a single-layer or multi-layer structure including the inorganic insulating material described above.

The pixel circuit PC may include a plurality of transistors and a storage capacitor as described above with reference to FIG. 4A or 4B. In this regard, FIG. 6 illustrates the first thin-film transistor T1, the third thin-film transistor T3, and the storage capacitor Cst.

The first thin-film transistor T1 may include a semiconductor layer (hereinafter referred to as a first semiconductor layer A1) on the buffer layer 201 and a gate electrode (hereinafter referred to as a first gate electrode GE1) overlapping the channel region C1 of the first semiconductor layer A1. The first semiconductor layer A1 may include a silicon-based semiconductor material, for example, polysilicon. The first semiconductor layer A1 may have the channel region C1 and a first region B1 and a second region D1 arranged on opposite sides of the channel region C1. The first region B1 and the second region D1 are regions having impurities of a higher concentration than the channel region C1, and one of the first region B1 and the second region D1 may correspond to a source region and the other may correspond to a drain region.

A first gate insulating layer 203 may be arranged between the first semiconductor layer A1 and the first gate electrode GE1. The first gate insulating layer 203 may include an inorganic insulating material, such as silicon oxide, silicon nitride, or silicon oxynitride, and may have a single-layer or multi-layer structure including the above-described inorganic insulating material.

The first gate electrode GE1 may include a conductive material including molybdenum (Mo), aluminum (Al), copper (Cu), and titanium (Ti) and may have a single layer or a multi-layered structure including the material described above.

The storage capacitor Cst may include a lower electrode CE1 and an upper electrode CE2 that overlap each other. In an embodiment, the lower electrode CE1 of the storage capacitor Cst may include the first gate electrode GE1. For example, the first gate electrode GE1 may include the lower electrode CE1 of the storage capacitor Cst. For example, the first gate electrode GE1 and the lower electrode CE1 of the storage capacitor Cst may be integrally formed.

A first interlayer insulating layer 205 may be arranged between the lower electrode CE1 and the upper electrode CE2 of the storage capacitor Cst. The first interlayer insulating layer 205 may include an inorganic insulating material, such as silicon oxide, silicon nitride, or silicon oxynitride, and may have a single-layer or multi-layer structure including the above-described inorganic insulating material.

The upper electrode CE2 of the storage capacitor Cst may include a low-resistance conductive material, such as molybdenum (Mo), aluminum (Al), copper (Cu), and/or titanium (Ti), and may have a single-layer or multi-layer structure including the material described above.

A second interlayer insulating layer 207 may be disposed on the storage capacitor Cst. The second interlayer insulating layer 207 may include an inorganic insulating material, such as silicon oxide, silicon nitride, or silicon oxynitride, and may have a single-layer or multi-layer structure including the above-described inorganic insulating material.

A semiconductor layer of the third thin-film transistor T3 (hereinafter referred to as a third semiconductor layer A3) may be disposed on the second interlayer insulating layer 207. The third semiconductor layer A3 may include an oxide-based semiconductor material. For example, the third semiconductor layer A3 may include a Zn oxide-based material, such as Zn oxide, In-Zn oxide, Ga-In-Zn oxide, etc. In some embodiments, the third semiconductor layer A3 may include an In-Ga-Zn-O (IGZO), an In-Sn-Zn-O (ITZO), or In-Ga-Sn-Zn-O (IGTZO) semiconductor including, in ZnO, a metal such as indium (In), gallium (Ga), tin (Sn).

The third semiconductor layer A3 may have a channel region C3 and a first region B3 and a second region D3 disposed on opposite sides of the channel region C3. One of the first region B3 and the second region D3 may be a source region and the other may be a drain region.

The third thin-film transistor T3 may include a gate electrode (hereinafter referred to as a third gate electrode GE3) overlapping the channel region C3 of the third semiconductor layer A3. The third gate electrode GE3 may have a double gate (or dual gate) structure including a lower gate electrode G3A disposed below the third semiconductor layer A3 and an upper gate electrode G3B disposed above the channel region C3.

The lower gate electrode G3A may be arranged on a same layer (e.g., the first interlayer insulating layer 205) as the upper electrode CE2 of the storage capacitor Cst. The lower gate electrode G3A may include a same material as the upper electrode CE2 of the storage capacitor Cst.

The upper gate electrode G3B may be disposed on the third semiconductor layer A3 with the second gate insulating layer 209 therebetween. The second gate insulating layer 209 may include an inorganic insulating material, such as silicon oxide, silicon nitride, or silicon oxynitride, and may have a single-layer or multi-layer structure including the above-described inorganic insulating material.

A third interlayer insulating layer 210 may be disposed on the upper gate electrode G3B. The third interlayer insulating layer 210 may include an inorganic insulating material, such as silicon oxynitride, and may have a single-layer or multi-layer structure including the inorganic insulating material described above.

FIG. 6 illustrates the first thin-film transistor T1 and the third thin-film transistor T3 described above with reference to FIG. 4A and illustrates that the first semiconductor layer A1 and the third semiconductor layer A3 are arranged on different layers. Although not illustrated in FIG. 6, the second, fifth, sixth, and seventh thin-film transistors T2, T5, T6, T7 described above with reference to FIG. 4A may have a same structure as the first thin-film transistor T1 described with reference to FIG. 6. For example, the second, fifth, sixth, and seventh thin-film transistors T2, T5, T6, T7 (see, e.g., FIG. 4A) may include a semiconductor layer disposed on a same layer (e.g., the buffer layer 201) as the first semiconductor layer A1 of the first thin-film transistor T1 and a gate electrode disposed on a same layer (e.g., first gate insulating layer 203) as the first gate electrode GE1 of the first thin-film transistor T1. The semiconductor layers of the second, fifth, sixth, and seventh thin-film transistors T2, T5, T6, T7 (see, e.g., FIG. 4A) may be integrally connected to the first semiconductor layer A1.

FIG. 6 illustrates an embodiment in which the first semiconductor layer A1 and the third semiconductor layer A3 are arranged on different layers, but the present disclosure is not limited thereto. In another embodiment, when the first thin-film transistor T1 and the third thin-film transistor T3 are the same NMOS as shown in FIG. 4B, the first semiconductor layer A1 may be disposed on a same layer as the third semiconductor layer A3, for example, on the second interlayer insulating layer 207, and the semiconductor layer of the fifth thin-film transistor T5 shown in FIG. 4B may be disposed on the buffer layer 201 as a semiconductor layer including polysilicon. For convenience of description, the following description describes an embodiment in which the first semiconductor layer A1 of the first thin-film transistor T1 includes polysilicon and the third semiconductor layer A3 of the third thin-film transistor T3 includes an oxide semiconductor.

The first thin-film transistor T1 and the third thin-film transistor T3 may be electrically connected to each other through a node connection line 166. The node connection line 166 may be arranged on the third interlayer insulating layer 210. One side (or one end) of the node connection line 166 may be connected to the first gate electrode GE1 of the first thin-film transistor T1, and the other side (or the other end) of the node connection line 166 may be connected to the third semiconductor layer A3 of the third thin-film transistor T3.

The node connection line 166 may include aluminum (Al), copper (Cu), and/or titanium (Ti), and may have a single layer or multiple layers including the materials described above. For example, the node connection line 166 may have a three-layer structure of a titanium layer/aluminum layer/titanium layer.

The first organic insulating layer 211 may be arranged on the node connection line 166. The first organic insulating layer 211 may include an organic insulating material. The organic insulating material may include acrylic, benzocyclobutene (BCB), polyimide, or hexamethyldisiloxane (HMDSO).

The data line DL and the driving voltage line PL may be arranged on the first organic insulating layer 211 and may be covered by the second organic insulating layer 213. The data line DL and the driving voltage line PL may include aluminum (Al), copper (Cu), and/or titanium (Ti), and may have a single layer or multiple layers including the materials described above. For example, the data line DL and the driving voltage line PL may have a three-layer structure of titanium layer/aluminum layer/titanium layer.

The second organic insulating layer 213 may include an organic insulating material, such as acrylic, BCB, polyimide, and/or HMDSO. FIG. 6 illustrates an embodiment in which the data line DL and the driving voltage line PL are formed on the first organic insulating layer 211, but the present disclosure is not limited thereto. In another embodiment, either the data line DL or the driving voltage line PL may be arranged on a same layer as the node connection line 166.

A light-emitting diode, for example, the organic light-emitting diode OLED, may be arranged on the second organic insulating layer 213.

A pixel electrode 221 of the organic light-emitting diode OLED may include a reflective layer including silver (Ag), magnesium (Mg), aluminum (Al), platinum (Pt), palladium (Pd), gold (Au), nickel (Ni), neodymium (Nd), iridium (Ir), chromium (Cr), or a compound thereof. In another embodiment, the pixel electrode 221 may further include a conductive oxide layer above and/or below the above-described reflective layer. The conductive oxide layer may include indium tin oxide (ITO), indium zinc oxide (IZO), zinc oxide (ZnO), indium oxide (In₂O₃), indium gallium oxide (IGO), and/or aluminum zinc oxide (AZO). In an embodiment, the pixel electrode 221 may have a three-layer structure of an ITO layer/Ag layer/ITO layer.

A bank layer 215 may be disposed on the pixel electrode 221. The bank layer 215 may have an opening that overlaps the pixel electrode 221 and may cover edges of the pixel electrode 221. The bank layer 215 may include an organic insulating material.

The intermediate layer 222 may include an emission layer 222b. The intermediate layer 222 may include a first functional layer 222a disposed below the emission layer 222b and/or a second functional layer 222c disposed above the emission layer 222b. The emission layer 222b may include a polymer or low-molecular weight organic material, which emits light of a certain color. The first functional layer 222a may include a hole transport layer (HTL) and/or a hole injection layer (HIL). The second functional layer 222c may include an electron transport layer (ETL) and/or an electron injection layer (EIL). The first functional layer 222a and the second functional layer 222c may include an organic material.

The opposite electrode 223 may include a conductive material having a low work function. For example, the opposite electrode 223 may include a (semi)transparent layer including Ag, Mg, Al, Pt, Pd, Au, Ni, Nd, Ir, Cr, Li, Ca, or an alloy thereof. In another embodiment, the opposite electrode 223 may further include a layer such as ITO, IZO, ZnO or In₂O₃ on the (semi)transparent layer including the above-described material.

The emission layer 222b may be formed in the display area DA to overlap the pixel electrode 221 through (or in) the opening in the bank layer 215. In some embodiments, the first functional layer 222a, the second functional layer 222c, and the opposite electrode 223 may extend to be located in the inner non-display area MA as well as in the display area DA.

A spacer 217 may be formed on the bank layer 215. The spacer 217 may be formed together with the bank layer 215 in a same process or may be formed individually in a separate process. In an embodiment, the spacer 217 may include an organic insulating material, such as polyimide.

The organic light-emitting diode OLED may be covered by an encapsulation layer 300. The encapsulation layer 300 may include at least one organic encapsulation layer and at least one inorganic encapsulation layer. In the embodiment illustrated in FIG. 6, the encapsulation layer 300 includes first and second inorganic encapsulation layers 310 and 330, and an organic encapsulation layer 320 therebetween.

The first inorganic encapsulation layer 310 and the second inorganic encapsulation layer 330 may each include at least one inorganic material selected from the group consisting of aluminum oxide, titanium oxide, tantalum oxide, hafnium oxide, zinc oxide, silicon oxide, silicon nitride, and silicon oxynitride. The first inorganic encapsulation layer 310 and the second inorganic encapsulation layer 330 may have a single layer or multi-layer structure including the above-described materials. The organic encapsulation layer 320 may include a polymer-based material. The polymer-based material may include an acrylic resin, an epoxy-based resin, polyimide, polyethylene, and the like. In an embodiment, the organic encapsulation layer 320 may include acrylate.

Thicknesses of the first inorganic encapsulation layer 310 and the second inorganic encapsulation layer 330 may be different from each other. The thickness of the first inorganic encapsulation layer 310 may be greater than the thickness of the second inorganic encapsulation layer 330. In another embodiment, the thickness of the second inorganic encapsulation layer 330 may be greater than the thickness of the first inorganic encapsulation layer 310, or the thicknesses of the first inorganic encapsulation layer 310 and the second inorganic encapsulation layer 330 may be same as each other.

The display panel 10 may include the substrate 100, a circuit-diode layer 200 disposed on the substrate 100 and including pixel circuits and light-emitting diodes, and the image generation layer 20 including the encapsulation layer 300. The input sensing layer 40 (see, e.g., FIG. 2) and the optical functional layer 50 (see, e.g., FIG. 2), etc., may be further disposed on the image generation layer 20 as described above with reference to FIG. 2.

Referring to the inner non-display area MA shown in FIG. 6, the inner non-display area MA may include a line bypass area through which the bypass portions DL-C1 and DL-C2 of the data lines DL described above with reference to FIG. 5 pass by.

The bypass portions DL-C1 and DL-C2 of the data lines DL may be arranged on different layers. One of the bypass portions DL-C1 and DL-C2 of the neighboring data lines DL may be arranged on the third interlayer insulating layer 210, and the other one may be arranged on the first organic insulating layer 211.

When the bypass portions DL-C1 and DL-C2 of the data lines DL are alternately arranged with an insulating layer (e.g., a first planarization insulating layer, such as the first organic insulating layer 211) therebetween, a pitch Δd between the bypass portions DL-C1 and DL-C2 of the data lines DL may be reduced, and thus, the area thereof in the inner non-display area MA may be efficiently utilized.

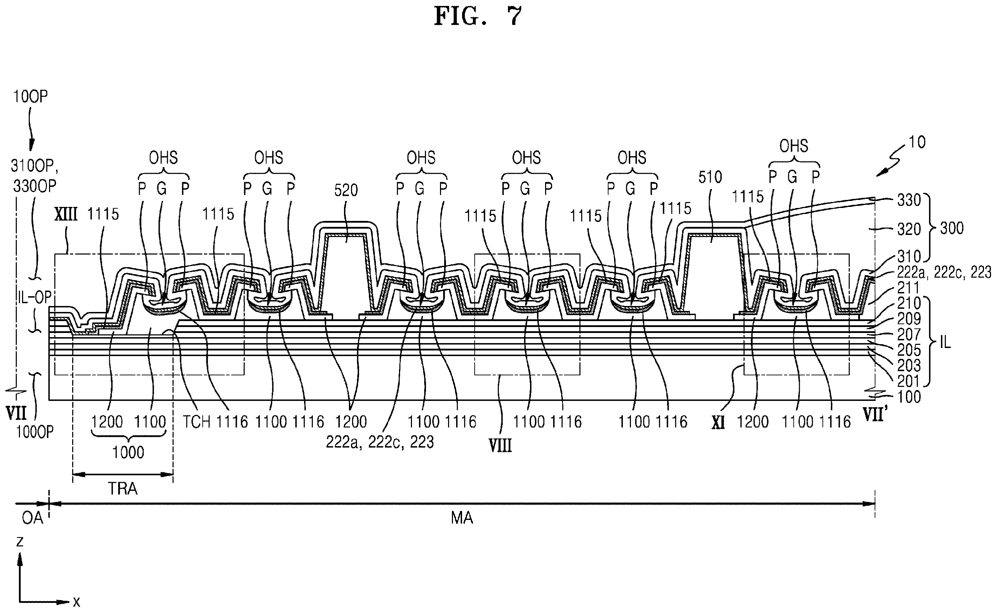

FIG. 7 is a cross-sectional view of the display panel 10 according to an embodiment, taken along the line VII-VII' in FIG. 5. Referring to FIGS. 5 and 7, the display panel 10 may have the opening 10OP corresponding to the opening area OA, and the inner non-display area MA may include structures for preventing crack propagation and/or moisture penetration. The opening 10OP in the display panel 10 may be formed by penetrating several layers constituting the display panel 10. In this regard, FIG. 7 illustrates an opening 100OP penetrating from a first surface (hereinafter, the upper surface) to a second surface (hereinafter, the lower surface) of the substrate 100, an opening IL-OP penetrating from an upper surface to a lower surface of an inorganic insulation structure IL, and openings 310OP and 330OP in the first and second inorganic encapsulation layers 310 and 330, respectively. The inorganic insulation structure IL is a stacked structure including a plurality of inorganic insulating layers. As an embodiment, the inorganic insulation structure IL may include the buffer layer 201, the first gate insulating layer 203, the first interlayer insulating layer 205, the second interlayer insulating layer 207, the second gate insulating layer 209, and the third interlayer insulating layer 210, as illustrated in FIG. 7.

For convenience of description, FIG. 7 illustrates a stacked structure from the substrate 100 to the encapsulation layer 300. However, as described above with reference to FIG. 2, the display panel 10 may further include the input sensing layer 40, the optical functional layer 50, and the cover window 60 on the encapsulation layer 300, and the input sensing layer 40 and the optical functional layer 50 may each have an opening corresponding to the opening area OA.

Referring to FIGS. 5 and 7, a trench TCH, overhang structures OHS, and first and second partition walls 510, 520 may be arranged in the inner non-display area MA. The encapsulation layer 300 may extend to the inner non-display area MA and may overlap or cover the trench TCH, the overhang structures OHS, and the first and second partition walls 510 and 520.

The overhang structures OHS may be arranged apart from each other in the inner non-display area MA. As an embodiment, referring to FIGS. 5 and 7, one overhang structure OHS may be arranged between the first partition wall 510 and the display area DA (see, e.g., FIG. 5), a plurality of overhang structures OHS (e.g., three overhang structures OHS) may be arranged between the first partition wall 510 and the second partition wall 520, and a plurality of overhang structures OHS (e.g., two overhang structures OHS) may be arranged between the second partition wall 520 and the opening 100OP in the substrate 100. In another embodiment, the plurality of overhang structures OHS may be arranged between the first partition wall 510 and the display area DA (see, e.g., FIG. 5). In another embodiment, two or more overhang structures OHS may be arranged between the first partition wall 510 and the second partition wall 520. In another embodiment, one or more or three or more overhang structures OHS (e.g., two overhang structures OHS) may be positioned between the second partition wall 520 and the opening 100OP in the substrate 100. As another embodiment, one or more partition walls (hereinafter referred to as third partition walls) may be further arranged between the first partition wall 510 and the second partition wall 520, one or more overhang structures OHS may be arranged between the first partition wall 510 and the third partition walls, and one or more overhang structures OHS may be arranged between the third partition walls and the second partition wall 520. For convenience of description, the structure illustrated in FIG. 7 is described in more detail below.

Each of the overhang structures OHS may have a closed loop shape surrounding (e.g., extending around) the opening area OA as illustrated in FIG. 5. Element or configuration "A" having a closed loop shape surrounding the opening area OA, on a plane, may indicate that the element or configuration "A" on a plane has a closed loop shape surrounding the opening 100OP in the substrate 100. Thus, the overhang structures OHS that may have a closed loop shape surrounding the opening area OA, on a plane, may indicate the overhang structures OHS on the plane each having a closed loop shape surrounding the opening 100OP in the substrate 100.

The overhang structures OHS may be defined in a multi-layer structure 1000 including a first layer 1100 and a second layer 1200 including different materials. The second layer 1200 may be positioned on the first layer 1100 and may have a smaller thickness than the first layer 1100. The overhang structures OHS may each have a groove G defined in the first layer 1100 and overhang portions P hanging over the groove G to form an eaves structure. In an embodiment, the overhang structures OHS may each have the groove G defined in the first layer 1100, as illustrated in FIG. 7, and two overhang portions P hanging over or extending toward each other above the groove G. In some embodiment, the multi-layer structures 1000 may be separated from each other in the inner non-display area MA. Referring to FIGS. 5 and 7, each of the multi-layer structures 1000 may have a closed loop shape surrounding (e.g., extending around) the opening area OA on a plane (e.g. in a plan view).

The first layer 1100 may include an insulating material. In an embodiment, the first layer 1100 may include an organic insulating material. For example, the material of the first layer 1100 may be same as the material of the first organic insulating layer 211 described with reference to FIG. 6. The groove G is a sunken portion along a thickness direction of (e.g., a reduced thickness portion of) the first layer 1100, and a depth of the groove G is less than the thickness of the first layer 1100.

The first layers 1100 may be arranged (or spaced) apart from each other in the inner non-display area MA. In a similar manner with the overhang structures OHS, the first layer 1100 may have a closed loop shape surrounding the opening area OA and/or the opening 100OP in the substrate 100 on a plane. In this specification, the phrase "on a plane" or "plan view" refers to viewing a target portion from the top, and the phrase "on a cross-section" refers to viewing a cross-section formed by vertically cutting a target portion from the side.

The second layer 1200 may include a conductive material. In an embodiment, the second layer 1200 may include a metal layer including a metal material including molybdenum (Mo), aluminum (Al), copper (Cu), titanium (Ti), or the like. The second layer 1200 may have a single-layer or multi-layer structure including the material described above. As an embodiment, the second layer 1200 may have a three-layer stacked structure of a titanium layer/aluminum layer/titanium layer. For example, the second layer 1200 may be formed in a same process as the data line DL and/or the driving voltage line PL described above with reference to FIG. 6 and may include a same material as that of the data line DL and/or the driving voltage line PL.

Two second layers 1200 may be arranged on either side of the groove G. The overhang portions P of each of the two second layers 1200 may hang over or protrude each other above the groove G to form an eaves shape. For example, two overhang portions P arranged on opposite sides of the groove G may extend toward each other while maintaining a gap therebetween.

The second layer 1200 disposed on one first layer 1100 may be integrally connected to the second layer 1200 disposed on another adjacent first layer 1100. For example, one second layer 1200 may extend over two adjacent first layers 1100 and may have overhang portions P extending over the groove G of each of the two first layers 1100. The second layer 1200, as described above, may be in contact with an upper surface of an uppermost layer of the inorganic insulation structure IL exposed between two adjacent first layers 1100 (e.g., the inorganic insulating layer positioned directly below the first layer 1100).

The protective layer 1115 may be positioned on the overhang portions P and protect the overhang portions P. The protective layer 1115 may be located on an upper surface and a side surface of each overhang portion P. The protective layer 1115 may include a conductive material. In an embodiment, the protective layer 1115 may include a same material as the pixel electrode 221 described above with reference to FIG. 6. The protective layer 1115 may have a three-layer structure of an ITO layer/Ag layer/ITO layer. In a process of forming the protective layer 1115, a material layer identical to the protective layer 1115 (hereinafter referred to as a protective material layer 1116) may be on a bottom surface of the groove G.

Each of the first functional layer 222a, the second functional layer 222c, and the opposite electrode 223 may be shared among the plurality of organic light-emitting diodes OLED. From among the layers included in the organic light-emitting diode OLED (see, e.g., FIG. 6), a layer including an organic material, for example, the first functional layer 222a and/or the second functional layer 222c, may be formed in the inner non-display area MA as well as the display area DA. In a comparative example, the first functional layer 222a and the second functional layer 222c, if formed continuously in the non-display area MA, may provide a moisture permeation path for moisture flowing in through the opening 10OP in the display panel 10, and the organic light-emitting diode OLED (see, e.g., FIG. 6) may be damaged by moisture.

However, according to embodiments of the present disclosure, the first functional layer 222a and/or the second functional layer 222c including an organic material from among the layers included in the light-emitting diode are separated into a plurality of portions by the overhang structures OHS in the inner non-display area MA. Accordingly, the path of moisture flowing in through the opening area OA is blocked, thereby preventing damage to the organic light-emitting diode OLED (see, e.g., FIG. 6). Similarly, the opposite electrode 223 may also be separated into a plurality of portions in the inner non-display area MA by the overhang structures OHS. In this regard, FIG. 7 illustrates an embodiment in which the first functional layer 222a, the second functional layer 222c, and the opposite electrode 223 are each separated into a plurality of portions in the inner non-display area MA. The first functional layer 222a, the second functional layer 222c, and the opposite electrode 223 may be separated into a portion disposed on the overhang portion P and a portion disposed on the bottom surface of the groove G, respectively.

The inner non-display area MA may have a trench area TRA that is relatively close to the opening area OA. The trench area TRA is an area at where the trench TCH defined in the inorganic insulation structure IL is arranged, and the trench TCH may have a shape sunken in a thickness direction of the inorganic insulation structure IL. Because the display panel 10 includes the trench TCH defined in the inorganic insulation structure IL, impacts that may occur during the manufacturing process of the display panel 10 (e.g., impacts occurring during the process of forming the opening 10OP in the display panel 10) and transmission of cracks due to the impacts to the display area DA may be prevented.

The trench TCH may be located between a partition wall closest to the opening area OA and the opening area OA. In this regard, FIG. 7 illustrates an embodiment in which the trench TCH is located between the second partition wall 520 and the opening area OA. A width of the trench TCH may be greater than a width of the groove G in the first layer 1100. A depth of the trench TCH may be less than a sum of thicknesses of the plurality of inorganic insulating layers of the inorganic insulation structure IL. In some embodiments, as illustrated in FIG. 7, the trench TCH passes through an upper surface and a lower surface of the third interlayer insulating layer 210, an upper surface and a lower surface of the second gate insulating layer 209, and an upper surface of the second interlayer insulating layer 207, but the present disclosure is not limited thereto.

One of the overhang structures OHS may overlap the trench TCH. For example, from among the overhang structures OHS, an overhang structure OHS positioned closest to the opening area OA may overlap the trench TCH.

In some embodiments, the first layer 1100 may be disposed on one of the peripheral portions on opposite sides of the trench TCH. The trench TCH may include a first edge portion that is relatively close to the opening area OA and a second edge portion that is opposite the first edge portion, and the first layer 1100 may be arranged on the second edge portion that is relatively far from the opening area OA from among the two edge portions of the trench TCH. The first layer 1100 may cover a step at the second edge portion of one side of the trench TCH.

The second layer 1200 on the first layer 1100 overlapping the trench TCH may include the overhang portion P extending toward the groove G, and a portion of the second layer 1200 opposite the overhang portion P may extend past a side surface of the first layer 1100 and onto a bottom surface of the trench TCH. The portion of the second layer 1200 described above may be in direct contact with the bottom surface of the trench TCH.

The encapsulation layer 300 may extend to the inner non-display area MA as well as the display area DA (see, e.g., FIG. 5). The first inorganic encapsulation layer 310 and the second inorganic encapsulation layer 330 may be arranged on the trench TCH, the overhang structure OHS, the first partition wall 510, and the second partition wall 520, respectively. The first inorganic encapsulation layer 310 and the second inorganic encapsulation layer 330 may each extend through the trench area TRA toward the opening area OA. The first inorganic encapsulation layer 310 may continuously cover the upper surface, side surface, and bottom surface of the overhang portion P, and an inner surface of the first layer 1100 defining the groove G.

A partition wall controls the flow of monomers when forming the organic encapsulation layer 320, and the organic encapsulation layer 320 may overlap some of the overhang structures OHS, for example, the overhang structure OHS between one of the partition walls and the display area DA (see, e.g., FIG. 5). The embodiment illustrated in FIG. 7 includes the organic encapsulation layer 320 overlapping the overhang structure OHS between the first partition wall 510 and the display area DA (see, e.g., FIG. 5).

The overhang structure OHS between the first partition wall 510 and the display area DA (see, e.g., FIG. 5) may overlap the first inorganic encapsulation layer 310, the organic encapsulation layer 320, and the second inorganic encapsulation layer 330.

The second inorganic encapsulation layer 330 may be in direct contact with the first inorganic encapsulation layer 310 in some areas of the inner non-display area MA. For example, the second inorganic encapsulation layer 330 may be in direct contact with the first inorganic encapsulation layer 310 between the partition wall and the opening area OA. In the embodiment illustrated in FIG. 7, a portion of the second inorganic encapsulation layer 330 may be in direct contact with a portion of the first inorganic encapsulation layer 310 over the overhang structures OHS between the first partition wall 510 and the second partition wall 520 and over the overhang structures OHS and the trench TCH between the second partition wall 520 and the opening area OA. The second inorganic encapsulation layer 330 and the first inorganic encapsulation layer 310 may also be in direct contact with each other on the partition wall. For example, a portion of the second inorganic encapsulation layer 330 above the first and second partition walls 510 and 520 may be in direct contact with a portion of the first inorganic encapsulation layer 310.

The first and second partition walls 510 and 520 may each be positioned between adjacent overhang structures OHS. The first partition wall 510 may cover ends of each of the second layers 1200 that are arranged on opposite sides of the first partition wall 510 and may extend over upper surfaces of the inorganic insulation structures IL and ends of the protective layers 1115 arranged on each of the second layers 1200. The second partition wall 520 may cover ends of each of the second layers 1200 that are arranged on opposite sides of the second partition wall 520 and extend over the upper surfaces of the inorganic insulation structures IL and the ends of the protective layers 1115 arranged on each of the second layers 1200. Each of the first and second partition walls 510 and 520 may have a closed curve shape surrounding the opening area OA on a plane. In an embodiment, a width of the first partition wall 510 may be greater than a width of the second partition wall 520.

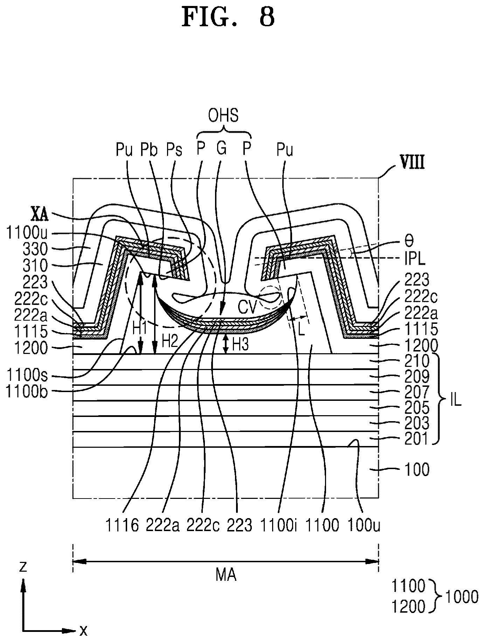

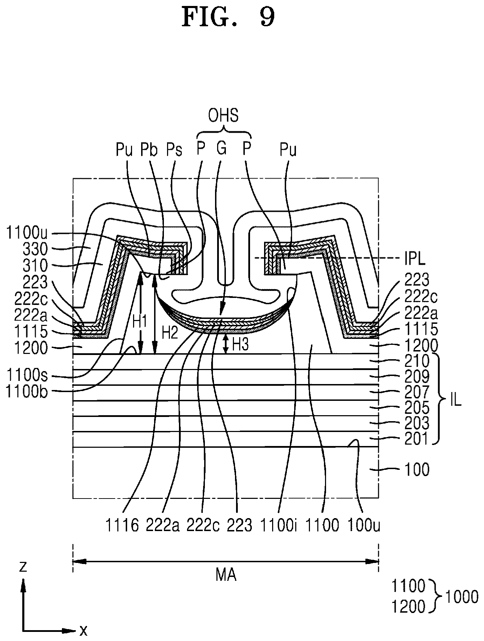

FIG. 8 is a cross-sectional view of a portion of the display panel 10 according to an embodiment and is an enlarged view of the region VIII in FIG. 7. FIG. 9 is a cross-sectional view of a portion of the display panel 10 according to another embodiment, and may correspond to an enlarged view of the region VIII in FIG. 7. The overhang structure OHS illustrated in FIGS. 8 and 9 is an overhang structure OHS located between adjacent partition walls, for example, between the first partition wall 510 and the second partition wall 520 (see, e.g., FIG. 7).

Referring to FIGS. 8 and 9, the overhang structure OHS may be positioned on the inorganic insulation structure IL. The overhang structure OHS may be defined in the multi-layer structure 1000, and the multi-layer structure 1000 may include the first layer 1100 and the second layer 1200 including different materials and having different thicknesses. The first layer 1100 may include an insulating material, and the second layer 1200 may include a conductive material. In an embodiment, the first layer 1100 may include an organic insulating material, such as acrylic, BCB, polyimide, or HMDSO, and may be formed as a single layer or multiple layers including the material described above. The second layer 1200 may include aluminum (Al), copper (Cu), and/or titanium (Ti), and may be formed as a single layer or multiple layers including the material described above.

The first layer 1100 may be arranged on an uppermost layer of the inorganic insulation structure IL, for example, the third interlayer insulating layer 210. The first layer 1100 may have a lower surface 1100b in contact with the upper surface of the third interlayer insulating layer 210, an inner surface 1100i defining the groove G, a side surface 1100s that is tapered in a forward direction (e.g., is tapered inwardly or toward a center thereof) with respect to the upper surface of the third interlayer insulating layer 210, and an upper surface 1100u extending between the side surface 1100s and the inner surface 1100i.

The upper surface 1100u of the first layer 1100 may be inclined downwardly from the outside toward the inside at where the groove G is located. Accordingly, a first vertical distance H1 from the upper surface of the inorganic insulation structure IL to a point at where the side surface 1100s and the upper surface 1100u of the first layer 1100 meet each other may be greater than a second vertical distance H2 from the upper surface of the inorganic insulation structure IL to a point at where the inner surface 1100i of the first layer 1100 and the bottom surface of the second layer 1200 meet each other. Because the depth of the groove G is less than the thickness of the first layer 1100, a third vertical distance H3 from the upper surface of the inorganic insulation structure IL to the portion corresponding to a center of the groove G is smaller than the second vertical distance H2.

The two second layers 1200 may be arranged on either side of the groove G of the first layer 1100. The second layers 1200 arranged on opposite sides with the groove G therebetween may each include the overhang portion P hanging over the groove G.

The second layer 1200 positioned on one side (e.g., the left side) of the groove G may include an overhang portion P extending (or hanging over) toward the groove G from a point at where a lower surface of the second layer 1200 and the inner surface 1100i of the first layer 1100 defining the groove G meet each other. Similarly, the second layer 1200 positioned on the other side (e.g., right side) of the groove G may include the overhang portion P extending (or hanging over) toward the groove G from a point at where the lower surface of the second layer 1200 and the inner surface 1100i of the first layer 1100 defining the groove G meet each other. A length L of the overhang portion P, for example, the length L from the point at where the lower surface of the second layer 1200 and the inner surface 1100i of the first layer 1100 meet each other to an edge (e.g., a side) of the overhang portion P may be in a range of about 0.2 micrometers to about 0.4 micrometers (0.2 µm ≤ L ≤ 0.4 µm).

The two second layers 1200 may each extend past the two side surfaces 1100s of the first layer 1100 onto the upper surface of the inorganic insulation structure IL. Each second layer 1200 may be in direct contact with the side surfaces 1100s of the first layer 1100 and the upper surface of the inorganic insulation structure IL.

An upper surface Pu of the overhang portion P may be located on an imaginary plane IPL parallel to an upper surface 100u of the substrate 100 or on a plane different from the imaginary plane IPL. A first angle (θ) between the imaginary plane IPL parallel to the upper surface 100u of the substrate 100 and the upper surface Pu of each overhang portion P may be in a range of about 0 degrees to about 40 degrees (0° ≤ θ ≤ 40°).

In an embodiment, each second layer 1200 may be tilted downwardly toward the groove G. For example, the first angle (θ) between the imaginary plane IPL parallel to the upper surface 100u of the substrate 100 and the upper surface Pu of each overhang portion P may be in a range of about 0 degrees to about 40 degrees (0°<θ ≤ 40°). For example, as illustrated in FIG. 8, the first angle (θ) may be in a range of about 0 degrees to about 30 degrees (0°<θ ≤ 30°).

In another embodiment, as illustrated in FIG. 9, the first angle (θ) may be about 0 degrees. For example, the upper surface Pu of the overhang portion P may be arranged on the imaginary plane IPL parallel to the upper surface 100u of the substrate 100.

As described above, when the first angle (θ) is in a range of about 0 degrees to about 40 degrees (0°<θ ≤ 40°), the overhang portion P may not be lifted from the first layer 1100 and separated from the first layer 1100. By preventing the lifting of the overhang portion P, exfoliation of the first inorganic encapsulation layer 310 and the second inorganic encapsulation layer 330 may be prevented.

The protective layer 1115 may be arranged on the second layer 1200. The protective layer 1115 may be arranged on the overhang portion P and in direct contact with the overhang portion P. The protective layer 1115 may be located on the upper surface Pu and a side surface Ps of the overhang portion P. The protective layer 1115 may extend to overlap the side surface 1100s of the first layer 1100 and the upper surface of the inorganic insulation structure IL. The protective layer 1115 may prevent a length of the overhang portion P (e.g., an eaves length) from being shortened due to damage to the overhang portion P during the manufacturing process of the display panel 10 (see, e.g., FIG. 7).

The protective layer 1115 may include a conductive material, for example, a same material as the pixel electrode 221 (see, e.g., FIG. 6). The protective layer 1115 may be formed through a deposition process, and the material forming the protective layer 1115 may also be deposited inside the groove G, and as illustrated in FIGS. 8 and 9, the protective material layer 1116 identical to the protective layer 1115 may be on the bottom surface of the groove G.

As described above with reference to FIG. 7, the organic layers included in the organic light-emitting diode, such as the first functional layer 222a and the second functional layer 222c, may be separated into a plurality of portions by the overhang structure OHS. As illustrated in FIGS. 8 and 9, each of the first functional layer 222a and the second functional layer 222c may include portions disposed on the overhang portions P and portions disposed inside the grooves G. A portion of each of the first functional layer 222a and the second functional layer 222c may be disposed on the protective layer 1115 on the overhang portion P, and another portion of each of the first functional layer 222a and the second functional layer 222c may be disposed on the protective material layer 1116 disposed on the bottom surface of the groove G.

Similarly, the opposite electrode 223 may also be separated into a plurality of portions. As illustrated in FIGS. 8 and 9, the opposite electrode 223 may include portions disposed on the overhang portions P and portions disposed in the grooves G. A portion of the opposite electrode 223 may be disposed on a portion of each of the first functional layer 222a and the second functional layer 222c above the overhang portion P, and another portion of the opposite electrode 223 may be disposed on another portion of each of the first functional layer 222a and the second functional layer 222c disposed on the bottom surface of the groove G.

Because the first inorganic encapsulation layer 310 has excellent step coverage, the first inorganic encapsulation layer 310 may extend continuously without being separated by the overhang structure OHS, as illustrated in FIGS. 8 and 9. For example, the first inorganic encapsulation layer 310 may continuously extend to overlap the upper surface Pu, the side surface Ps, and a bottom surface Pb of the overhang portion P. In some embodiments, upper surfaces of the first inorganic encapsulation layer 310 may contact each other between adjacent overhang portions P. In such an embodiment, a cavity CV may exist, as shown in the cross-section as illustrated in FIG. 8. In another embodiment, the cavity CV may not be present, as illustrated in FIG. 9, depending on the thickness of the first inorganic encapsulation layer 310 and/or a gap between the overhang portions P.

The second inorganic encapsulation layer 330 may also have excellent step coverage and may extend continuously without being separated by the overhang structure OHS. As illustrated in FIGS. 8 and 9, the second inorganic encapsulation layer 330 may be in direct contact with the first inorganic encapsulation layer 310 over some of the overhang structures OHS illustrated in FIG. 7.

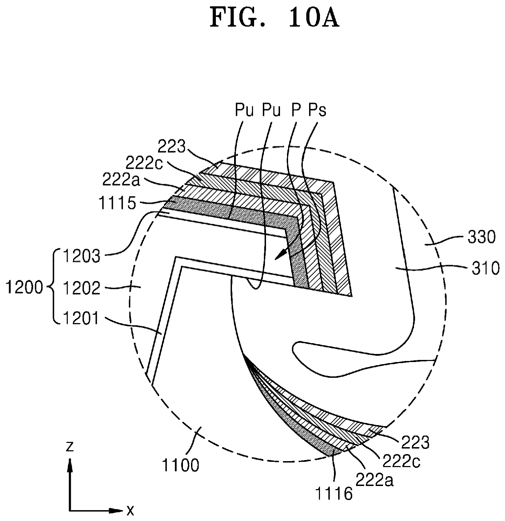

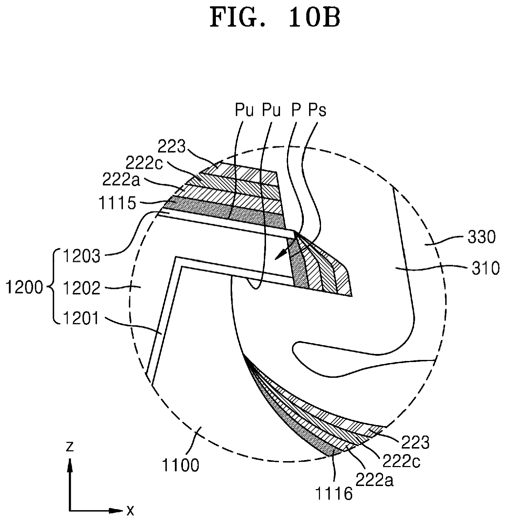

FIG. 10A is a cross-sectional view of a portion of the display panel 10 according to an embodiment and is an enlarged view of the region XA in FIG. 8, and FIG. 10B is a cross-sectional view of a portion of the display panel 10 according to another embodiment, and corresponds to a modified example of FIG. 10A.

Referring to FIGS. 10A and 10B, the second layer 1200 may include first to third sub-layers 1201, 1202, and 1203 including different materials. For example, from among the sub-layers of the second layer 1200, the first sub-layer 1201 may include a titanium layer, the second sub-layer 1202 may include an aluminum layer, and the third sub-layer 1203 may include a titanium layer.

In an embodiment, referring to FIG. 10A, the protective layer 1115 may continuously extend from the upper surface Pu of the overhang portion P toward the side surface Ps to cover the side surface Ps of the overhang portion P of the second layer 1200, for example, respective side surfaces of the first to third sub-layers 1201, 1202, 1203.

In another embodiment, because the etching selectivities of the first to third sub-layers 1201, 1202, and 1203 are different from each other, in the formation process of the second layer 1200, unevenness may be formed on the side surface Ps of the overhang portion P, as illustrated in FIG. 10B. Due to the unevenness, a portion of the protective layer 1115 formed on the second layer 1200, for example, the portion located on the upper surface Pu of the overhang portion P, and a portion of the protective layer 1115, for example, the portion located on the side surface Ps of the overhang portion P, may be discontinuous.

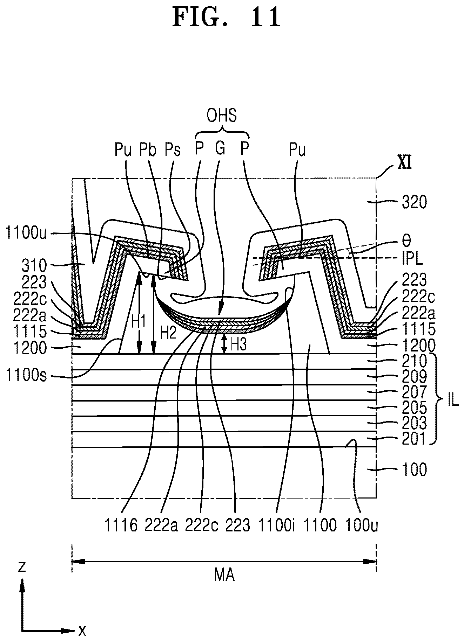

FIG. 11 is a cross-sectional view of a portion of the display panel 10 according to an embodiment and is an enlarged view of the region XI in FIG. 7. The overhang structure OHS illustrated in FIG. 11 illustrates the overhang structure OHS located between the first partition wall 510 (see, e.g., FIG. 7) closest to the display area DA (see, e.g., FIG. 5) and the display area DA (see, e.g., FIG. 5).

Referring to FIG. 11, the overhang structure OHS located between the first partition wall 510 (see, e.g., FIG. 7) and the display area DA (see, e.g., FIG. 5) may have a same structure as the structure described above with reference to FIG. 8. The overhang structure OHS may include the overhang portions P hanging over the groove G of the first layer 1100.

In an embodiment, the upper surface 1100u of the first layer 1100 may extend toward the groove G but may be inclined downwardly. Accordingly, a first vertical distance H1 from the upper surface of the inorganic insulation structure IL to a point at where the side surface 1100s and the upper surface 1100u of the first layer 1100 meet each other may be greater than a second vertical distance H2 from the upper surface of the inorganic insulation structure IL to a point at where the inner surface 1100i of the first layer 1100 and the bottom surface of the second layer 1200 meet each other. Because the depth of the groove G is less than the thickness of the first layer 1100, a third vertical distance H3 from the upper surface of the inorganic insulation structure IL to the portion corresponding to a center of the groove G is smaller than the second vertical distance H2.

The first angle (θ) between the upper surface Pu of the overhang portion P of the second layer 1200 arranged on the first layer 1100 and the imaginary plane IPL parallel to the upper surface 100u of the substrate 100 may be in a range of about 0 degrees to about 40 degrees (0°≤ θ ≤ 40°), as described above with reference to FIGS. 8 and 9. In an embodiment, the first angle (θ) between the imaginary plane IPL and the upper surface Pu of each overhang portion P may be in a range of 0°≤ θ ≤ 30°.

The two second layers 1200 may be arranged on either side of the groove G of the first layer 1100. Each of the two second layers 1200 may include the overhang portion P extending toward (e.g., hanging over) the groove from a point at where the lower surface of the second layer 1200 and the inner surface 1100i of the first layer 1100 defining the groove G meet each other. The length of the overhang portion P may be in a range of about 0.2 micrometer to about 0.4 micrometer.

The protective layer 1115 may be arranged on the overhang portion P and may be in direct contact with the overhang portion P. The protective layer 1115 may be located on the upper surface Pu and the side surface Ps of the overhang portion P. The protective layer 1115 may extend to overlap the side surface 1100s of the first layer 1100 and the upper surface of the inorganic insulation structure IL. The protective material layer 1116 includes a same material as the protective layer 1115 and may be on the bottom surface of the groove G.

As described above with reference to FIG. 7, organic layers included in the organic light-emitting diode, such as the first functional layer 222a and the second functional layer 222c, may be separated into a plurality of portions by the overhang structure OHS. As illustrated in FIGS. 8 and 9, each of the first functional layer 222a and the second functional layer 222c may include portions disposed on the overhang portions P and portions disposed in the grooves G. Similarly, the opposite electrode 223 may also be separated into a plurality of portions.

The protective layer 1115, the first functional layer 222a, the second functional layer 222c and the opposite electrode 223 on the overhang portion P may be arranged on the upper surface Pu and the side surface Ps of the overhang portion P and may be continuous as described above with reference to FIG. 10A or discontinuous as described with reference to FIG. 10B.

Because the first inorganic encapsulation layer 310 has excellent step coverage, the first inorganic encapsulation layer 310 may extend continuously without being separated by the overhang structure OHS, as illustrated in FIG. 11. The organic encapsulation layer 320 may be arranged on the first inorganic encapsulation layer 310 in the inner non-display area MA but may overlap with the overhang structure OHS as illustrated in FIG. 11.

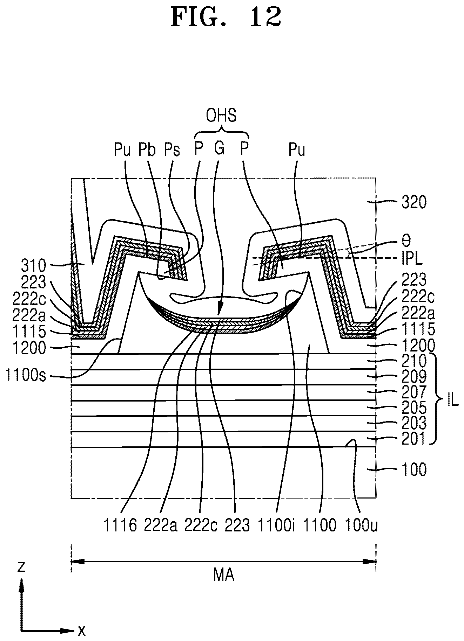

FIG. 12 is a cross-sectional view of a portion of the display panel 10 according to another embodiment. FIG. 12 may correspond to an enlarged view of the region XI in FIG. 7. The structure according to the embodiment illustrated in FIG. 12 is substantially same as the structure according to the embodiment described above with reference to FIG. 11 except that the upper surface 1100u of the first layer 1100 is substantially not present (or is substantially omitted).

Referring to FIG. 12, the side surface 1100s of the first layer 1100 and the inner surface 1100i defining the groove G may meet each other. The second layer 1200 may be arranged on the first layer 1100. The first angle (θ) between the upper surface Pu of the overhang portion P of the second layer 1200 and the imaginary plane IPL parallel to the upper surface 100u of the substrate 100 may be in a range of about 0 degrees to about 40 degrees (0°≤ θ ≤ 40°), as described above with reference to FIGS. 8 and 9. In some embodiments, the first angle (θ) may be in a range of 0°s θ ≤ 30°.

The protective layer 1115, the first functional layer 222a, the second functional layer 222c, and the opposite electrode 223 are as described above with reference to FIG. 11. The first inorganic encapsulation layer 310 may extend continuously without being separated by the overhang structure OHS. The organic encapsulation layer 320 may be arranged on the first inorganic encapsulation layer 310 in the inner non-display area MA but may overlap with the overhang structure OHS as illustrated in FIG. 11. From among the features illustrated in FIG. 12, a description of those features identical or substantially similar to those described above with respect to FIG. 11 are omitted for convenience.

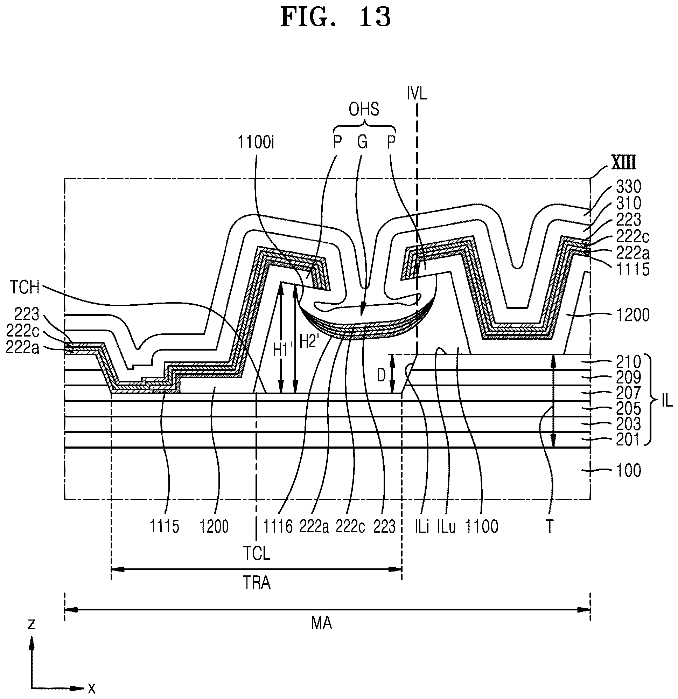

FIG. 13 is a cross-sectional view of a portion of the display panel 10 according to an embodiment and is an enlarged view of the region XIII in FIG. 7.

Referring to FIG. 13, the trench TCH having a sunken (e.g., concave) shape with respect to an upper surface ILu of the inorganic insulation structure IL may be arranged in the inner non-display area MA. The trench area TRA in which the trench TCH is arranged as a portion of the inner non-display area MA may be arranged close to the opening area OA as described above with reference to FIG. 7. The trench TCH may have a closed loop shape that entirely surrounds the opening area OA on a plane.

A depth D of the trench TCH may be less than a sum of thicknesses T of the plurality of inorganic insulating layers of the inorganic insulation structure IL. In the embodiment illustrated in FIG. 13, the trench TCH passes through the upper surface and the lower surface of the third interlayer insulating layer 210, the upper surface and the lower surface of the second gate insulating layer 209, and the upper surface of the second interlayer insulating layer 207 in a depth direction, and the bottom surface of the trench TCH is located between the upper and lower surfaces of the second interlayer insulating layer 207. However, the present disclosure is not limited thereto. In another embodiment, when the depth D of the trench TCH is less than the sum of the thicknesses T of the plurality of inorganic insulating layers of the inorganic insulation structure IL, the trench TCH may be formed by removing a plurality of layers selected from among the layers included in the inorganic insulation structure IL.

The first layer 1100 may be arranged to overlap the trench TCH. The trench TCH may have a first edge portion and a second edge portion respectively arranged on opposite sides with respect to an imaginary line TCL passing through a center of the trench TCH in a width direction. The first edge portion (e.g., the left edge portion in FIG. 13) may be relatively adjacent to the opening area OA, and the second edge portion (e.g., the right edge portion in FIG. 13) may be relatively adjacent to the display area DA (see, e.g., FIG. 5) as the opposite side to the first edge portion. The first layer 1100 may overlap the second edge portion of the trench TCH relatively adjacent to the display area DA (see, e.g., FIG. 5).

The first layer 1100 may cover a step of the second edge portion, for example, a step formed by an inner surface ILi of the inorganic insulation structure IL defining the trench TCH and the upper surface ILu of the inorganic insulation structure IL. The first layer 1100 may overlap a point at where the inner surface ILi and the upper surface ILu of the inorganic insulation structure IL defining the trench TCH meet each other. The groove G in the first layer 1100 may overlap one edge portion of the trench TCH (e.g., the right edge portion in FIG. 13).

The two second layers 1200 may be arranged on the first layer 1100 and on opposite sides of the groove G of the first layer 1100 with respect to the groove G. Each of the two second layers 1200 may have the overhang portion P extending toward (or hanging over) the groove G from a point at where the lower surface of the second layer 1200 and the inner surface 1100i of the first layer 1100 defining the groove G meet each other. The length of the overhang portion P may be in a range of about 0.2 micrometer to about 0.4 micrometer.

In an embodiment, the upper surface of the first layer 1100 may be tilted downwardly toward the groove G. For example, a first vertical distance H1' from a bottom surface of the trench TCH to the point at where the side surface 1100s and the upper surface 1100u of the first layer 1100 meet each other may be greater than a second vertical distance H2' from the bottom surface of the trench TCH to the point at where the inner surface 1100i of the first layer 1100 and the bottom surface of the second layer 1200 meet each other.

The overhang portion P of the second layer 1200 may extend toward the groove G and may be tilted downwardly so that the upper surface of the overhang portion P is substantially parallel to the upper surface of the substrate 100 or has an angle (e.g., a non-zero angle) with respect to an imaginary plane parallel to the upper surface 100u of the substrate 100 as described above with reference to FIGS. 8 and 9. In the embodiment illustrated in FIG. 13, the overhang portion P of the second layer 1200 extends toward the groove G but is tilted downwardly.

At least one of the overhang portions P may overlap the trench TCH. In an embodiment, the overhang portion P arranged on one side of the groove G (e.g., the left side of the groove G in FIG. 13) may overlap the trench TCH, and the overhang portion P disposed on the other side of the groove G (e.g., the right side of the groove G in FIG. 13) may not overlap the trench TCH. For example, an edge of the overhang portion P positioned on the other side of the groove G (e.g., the right side of the groove G in FIG. 13) may not extend toward the groove G past an imaginary line IVL passing through the point at where the inner surface ILi and the upper surface ILu of the inorganic insulation structure IL meet each other. The overhang portion P arranged on the other side of the groove G (e.g., the right side of the groove G in FIG. 13) may overlap with the upper surface ILu of the inorganic insulation structure IL.

Any one of the second layers 1200 arranged on opposite sides of the groove G (e.g., the second layer 1200 arranged on the left side of the groove G in FIG. 13) may include a portion that is located on the opposite side to the overhang portion P and extends toward the trench TCH. The portion described above may be in direct contact with the bottom surface of the trench TCH. A portion of another one of the second layers 1200 arranged on opposite sides of the groove G (e.g., the second layer 1200 arranged on the right side of the groove G in FIG. 13) may be in direct contact with the upper surface ILu of the inorganic insulation structure IL.

The protective layer 1115 may be arranged on the second layer 1200 to cover each overhang portion P. A portion of the protective layer 1115 on the second layer 1200 arranged to overlap the trench TCH may be arranged on the upper surface and side surface of the overhang portion P, and another portion of the protective layer 1115 may extend further past an edge of the second layer 1200 onto the bottom surface of the trench TCH and may be in direct contact with the bottom surface of the trench TCH. Accordingly, a side surface of an end of the second layer 1200 located opposite the overhang portion P may overlap (e.g., may be covered by) the protective layer 1115. When forming the protective layer 1115, the protective material layer 1116 may be arranged on the bottom surface of the groove G. The protective layer 1115 and the protective material layer 1116 may be separated from each other by the overhang portion P and may include a same material.

The first functional layer 222a and the second functional layer 222c may each be deposited in the inner non-display area MA, and each of the first functional layer 222a and the second functional layer 222c may be separated into a plurality of portions by the overhang portion P. As illustrated in FIG. 13, a portion of each of the first functional layer 222a and the second functional layer 222c may be disposed on the protective layer 1115 above each overhang portion P, and another portion thereof may be disposed on the protective material layer 1116 disposed on the bottom surface of the groove G. A portion of the first functional layer 222a arranged on one side of the groove G (e.g., the left side of the groove G in FIG. 13) may be in direct contact with the bottom surface of the trench TCH.

Because the first inorganic encapsulation layer 310 has excellent step coverage, the first inorganic encapsulation layer 310 may extend continuously without being separated by the overhang structure OHS, as illustrated in FIGS. 8 and 9.

According to an embodiment, as illustrated in FIG. 13, because the display panel 10 has the trench TCH, cracks occurring around the opening area OA (see, e.g., FIG. 7) during the formation process of the display panel 10 may be prevented from progressing toward the display area DA (see, e.g., FIG. 7). Propagation of cracks may be prevented or minimized by the structure of the trench TCH. Additionally, the second layer 1200 and/or the first layer 1100 overlapping the trench TCH may absorb impact or minimize crack propagation toward the display area DA (see, e.g., FIG. 7) together with the trench TCH.

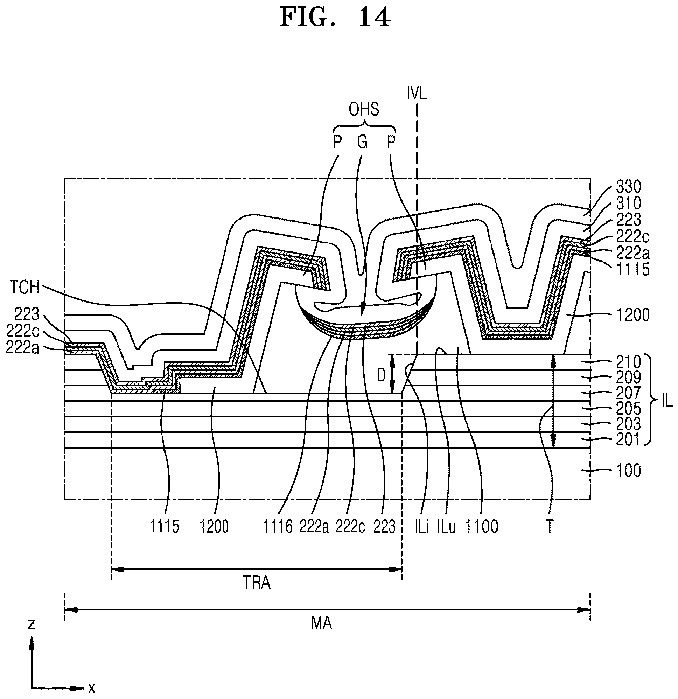

FIG. 14 is a cross-sectional view of a portion of the display panel 10 according to another embodiment. FIG. 14 may correspond to an enlarged view of the region XIII in FIG. 7.

The structure according to the embodiment shown in FIG. 14 is substantially the same as the embodiment described with reference to FIG. 13 except for the structure of the overhang portion P arranged on the right side of the groove G. Referring to FIG. 7 and FIG. 14, from among the overhang portions P on the trench TCH, the overhang portion P relatively adjacent to the display area DA (see, e.g., FIG. 7) may extend toward the groove G through the imaginary line IVL passing through the point at where the inner surface ILi and the upper surface ILu of the inorganic insulation structure IL meet each other. Other features than the structure described above are same or substantially similar as those described with reference to FIG. 13, and, thus, a repeated description thereof is omitted.

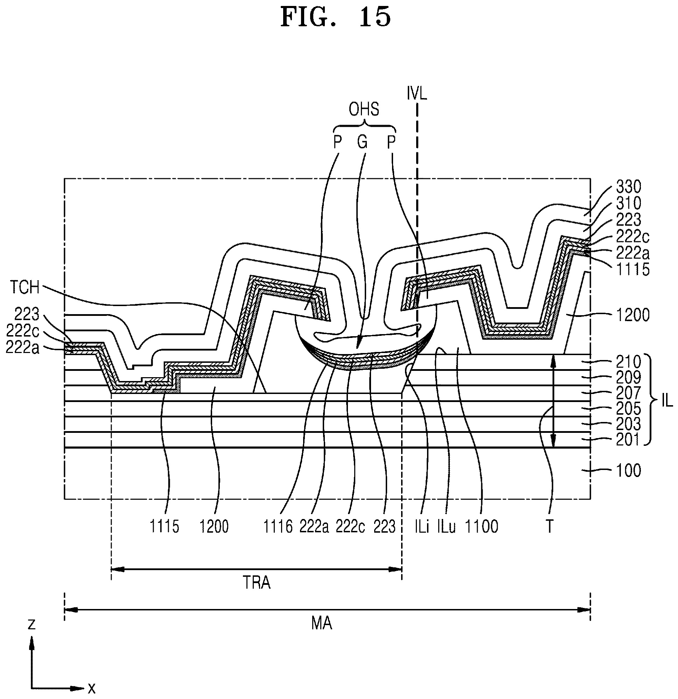

FIG. 15 is a cross-sectional view of a portion of the display panel 10 according to another embodiment. FIG. 15 may correspond to an enlarged view of the region XIII in FIG. 7.

The structure according to the embodiment shown in FIG. 15 is substantially the same as the embodiment described with reference to FIG. 13 except for the structure of the first layer 1100. In the embodiment shown in FIG. 13, the inner surface 1100i of the first layer 1100, which defines the groove G, is located on the point at where the inner surface ILi and the upper surface ILu of the inorganic insulation structure IL meet each other, but the present disclosure is not limited thereto. In another embodiment, as illustrated in FIG. 15, the point at where the inner surface ILi and the upper surface ILu of the inorganic insulation structure IL meet each other may be located on a same surface as the inner surface 1100i of the first layer 1100. In some embodiments, the first layer 1100 may be separated into two portions with respect to the point described above. Other features other than the structure described above are same or substantially similar as those described with reference to FIG. 13, and, thus, a repeated description thereof is omitted.

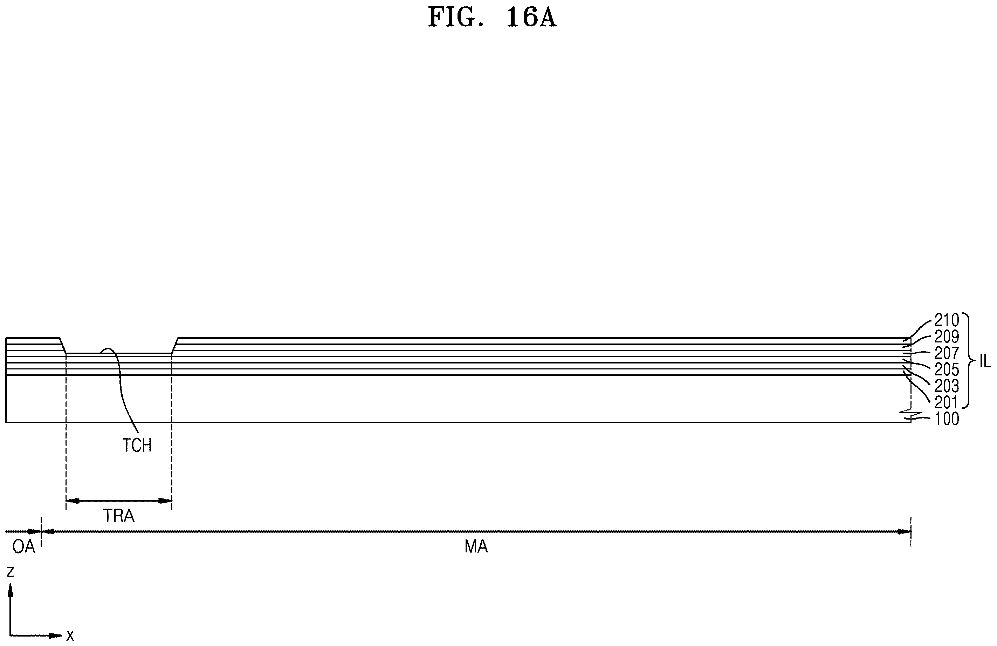

FIGS. 16A to 16G are cross-sectional views of the inner non-display area MA showing steps of a manufacturing process of the display panel 10 according to an embodiment.

Referring to FIG. 16A, the inorganic insulation structure IL is formed on the substrate 100. The inorganic insulation structure IL may include the buffer layer 201, the first gate insulating layer 203, the first interlayer insulating layer 205, and the second interlayer insulating layer 207. The inorganic insulation structure IL may be formed in the display area (DA, see, e.g., FIG. 5), the inner non-display area MA, and the opening area OA.

A portion of the inorganic insulation structure IL is removed to form the trench TCH in the inner non-display area MA. The trench area TRA in which the trench TCH is arranged corresponds to a portion of the inner non-display area MA adjacent to the opening area OA. The depth of the trench TCH may be less than a sum of the thicknesses of the plurality of inorganic insulating layers of the inorganic insulation structure IL. The trench TCH may completely surround the opening area OA on a plane.

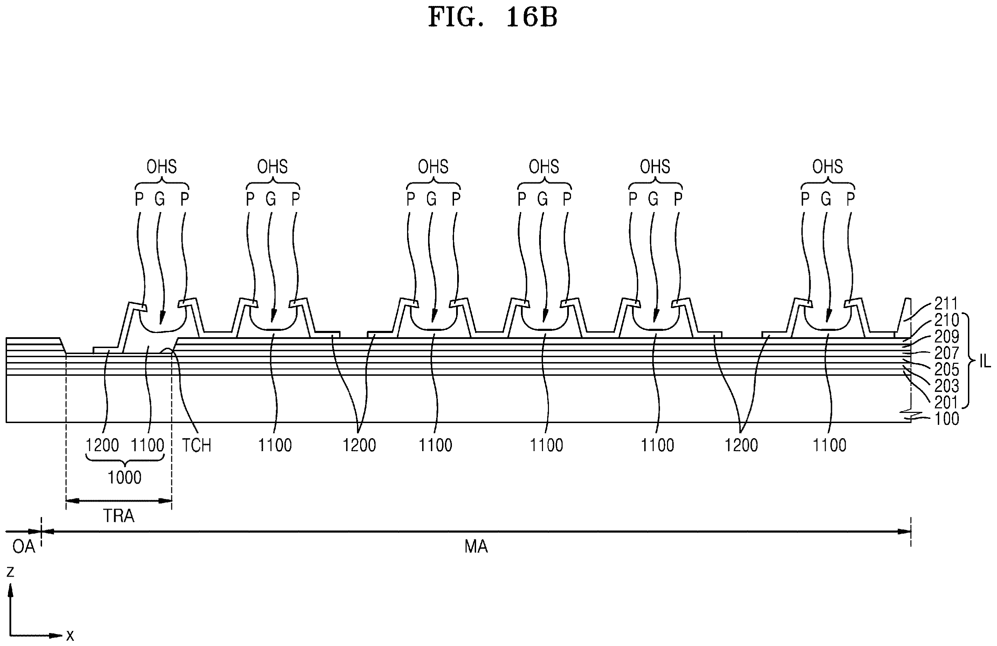

Referring to FIG. 16B, the plurality of overhang structures OHS are formed in the inner non-display area MA. The overhang structures OHS may be formed in the multi-layer structure 1000 including the first layer 1100 and the second layer 1200.

The first layers 1100 may be spaced apart from each other in the inner non-display area MA. Each of the first layers 1100 may have a groove G, and the second layers 1200 including the overhang portion P hanging over the groove G may be arranged on opposite sides with respect to the groove G. The second layer 1200 may pass through the side surface of the first layer 1100 and may directly contact the upper surface of the inorganic insulation structure IL (e.g., the upper surface of the third interlayer insulating layer 210).

The first layer 1100 overlapping the trench TCH may be shifted from an imaginary line passing through the center of the trench TCH to overlap one edge portion of the trench TCH. The first layer 1100, the second layer 1200, and the overhang structure OHS above the trench TCH may be same as the embodiment described above with reference to FIGS. 13 to 15.

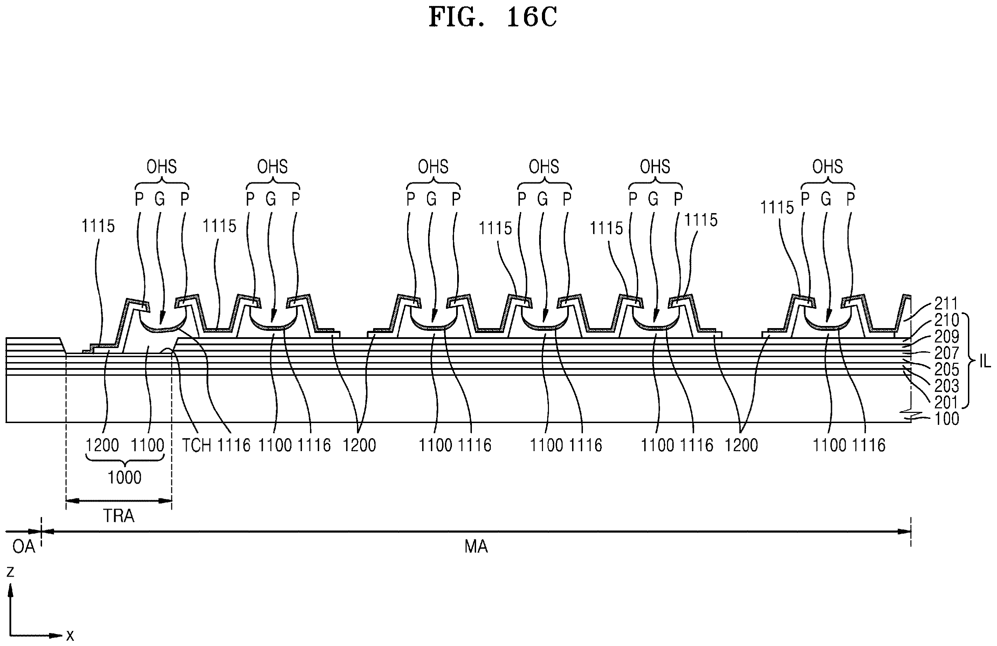

Referring to FIG. 16C, the protective layer 1115 may be formed on the overhang portion P. The protective layer 1115 may be formed in a process of forming the pixel electrode 221. The protective layer 1115 may include a same material as the pixel electrode 221. A material forming the protective layer 1115 may be deposited in the inner non-display area MA, and thus, the protective material layer 1116 separated from the protective layer 1115 by the overhang portion P and including a same material as the protective layer 1115 may be formed in the groove G.

From among the protective layers 1115, the protective layer 1115 positioned in the trench area TRA may extend past the edge of the second layer 1200 positioned in the trench area TRA to be in direct contact with the bottom surface of the trench TCH.

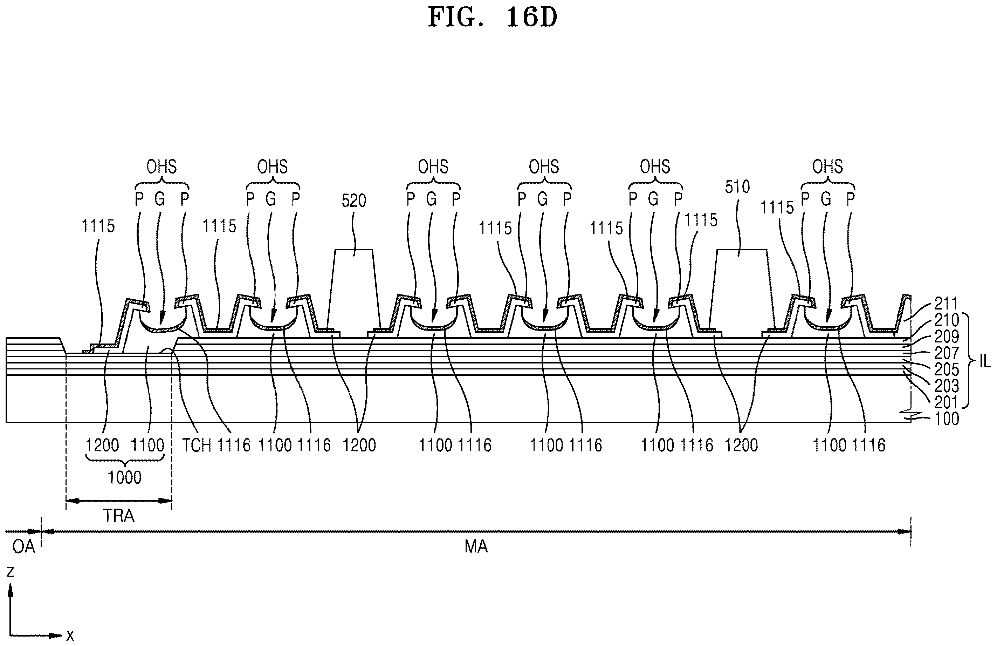

Referring to FIG. 16D, the first partition wall 510 and the second partition wall 520 spaced apart from each other may be formed in the inner non-display area MA. Although FIG. 16D illustrates an embodiment including two partition walls, the first partition wall 510 and the second partition wall 520, in other embodiments, the inner non-display area MA may further include one or more partition walls between the first partition wall 510 and the second partition wall 520.

The first partition wall 510 and the second partition wall 520 may each entirely surround the opening area OA on a plane. The first partition wall 510 may be relatively adjacent to the display area (DA, see, e.g., FIG. 5) and the second partition wall 520 may be relatively adjacent to the opening area OA.

The first partition wall 510 is positioned between two overhang structures OHS but may overlap (or cover) an end of the second layer 1200. The first partition wall 510 may overlap (or cover) an end of the protective layer 1115 on the second layer 1200.

The second partition wall 520 may be positioned between the two overhang structures OHS and may overlap (or cover) the end of the second layer 1200. The second partition wall 520 may overlap (or cover) the end of the protective layer 1115 on the second layer 1200.

The width of the second partition wall 520 may be less than the width of the first partition wall 510. The first partition wall 510 and the second partition wall 520 may each include an organic insulating material. The first partition wall 510 and the second partition wall 520 may each include a material, such as the bank layer 215 and/or the spacer 217 of the display area (DA, see, e.g., FIG. 5).

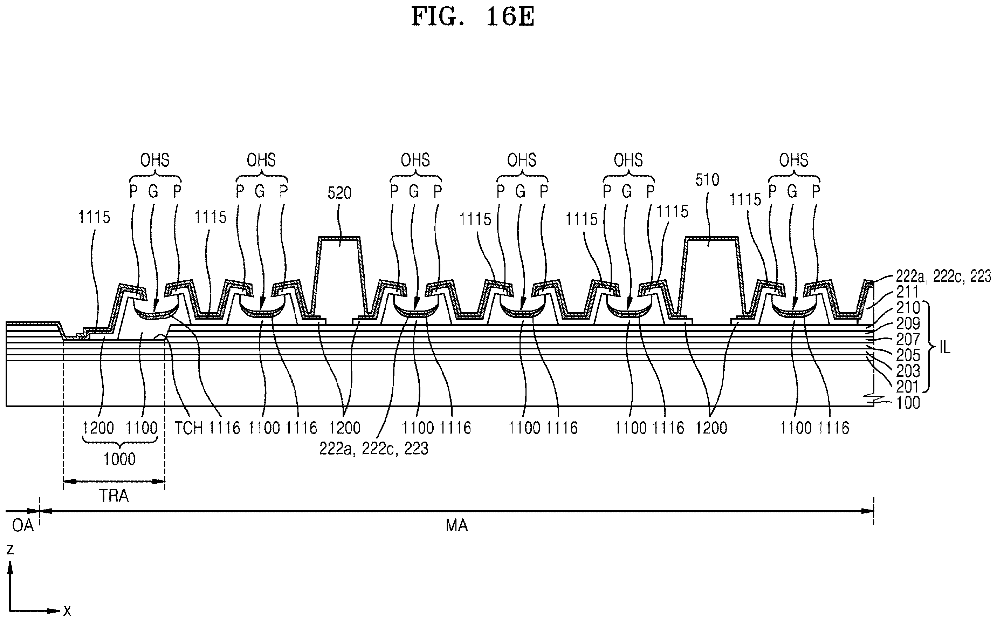

Referring to FIG. 16E, the first and second functional layers 222a and 222c and the opposite electrode 223 of the organic light-emitting diode (OLED, see, e.g., FIG. 6) may be formed. The first and second functional layers 222a, 222c and the opposite electrode 223 may be formed through a thermal deposition method. Each of the first and second functional layers 222a, 222c and the opposite electrode 223 may be deposited in the inner non-display area MA. However, due to the eaves structure of the overhang portion P formed in the inner non-display area MA, each of the first and second functional layers 222a, 222c and the opposite electrode 223 may be separated into a plurality of portions. Accordingly, external moisture may be prevented from progressing toward the organic light-emitting diode (OLED, see, e.g., FIG. 6) through the first and second functional layers 222a, 222c and the opposite electrode 223.

FIG. 16E illustrates each of the first and second functional layers 222a, 222c including a portion positioned on the overhang portion P and a portion positioned on the bottom surface of the groove G. Similarly, the opposite electrode 223 may include a portion positioned on the overhang portion P and a portion positioned on the bottom surface of the groove G.

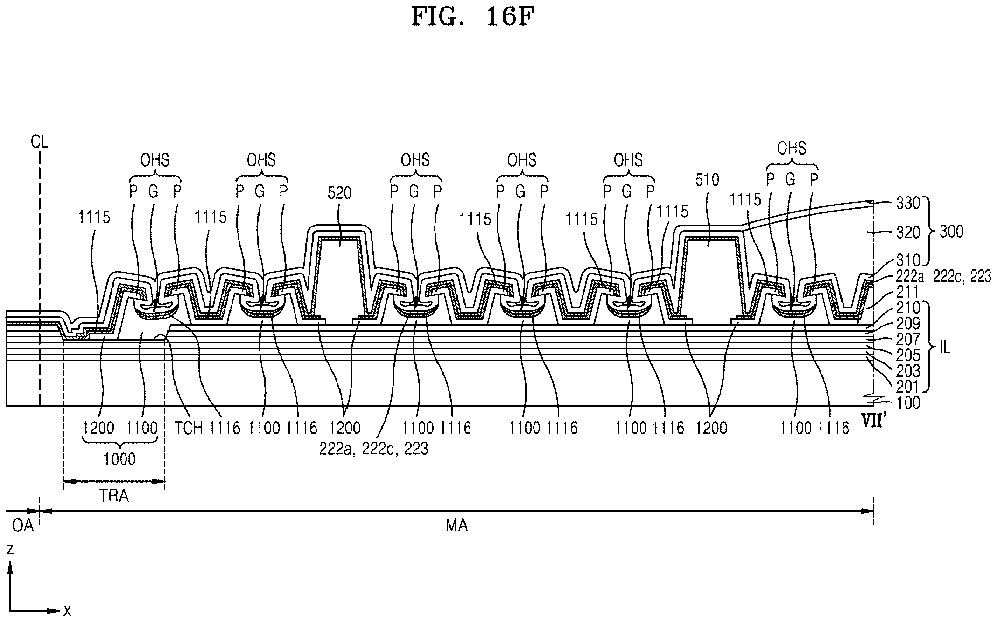

Referring to FIG. 16F, the encapsulation layer 300 may be formed. The first inorganic encapsulation layer 310 may be formed through a chemical vapor deposition method. Because the first inorganic encapsulation layer 310 has relatively excellent step coverage, the first inorganic encapsulation layer 310 may continuously cover the overhang portion P without being separated by the overhang portion P. The first inorganic encapsulation layer 310 may continuously cover the upper surface, the side surface, and the lower surface of the overhang portion P. The first inorganic encapsulation layer 310 may continuously cover side surfaces and an upper surface of the first partition wall 510 and may also continuously cover side surfaces and an upper surface of the second partition wall 520.

Next, a monomer may be applied and cured to form the organic encapsulation layer 320. The first partition wall 510 and the second partition wall 520 control the flow of monomer, and in an embodiment, as illustrated in FIG. 16F, the edge of the organic encapsulation layer 320 may be located on one side of the first partition wall 510. In another embodiment, a portion of the organic encapsulation layer 320 may be present between the first partition wall 510 and the second partition wall 520.

The second inorganic encapsulation layer 330 may be formed on the organic encapsulation layer 320, and the second inorganic encapsulation layer 330 may be in direct contact with the first inorganic encapsulation layer 310 in the inner non-display area MA.

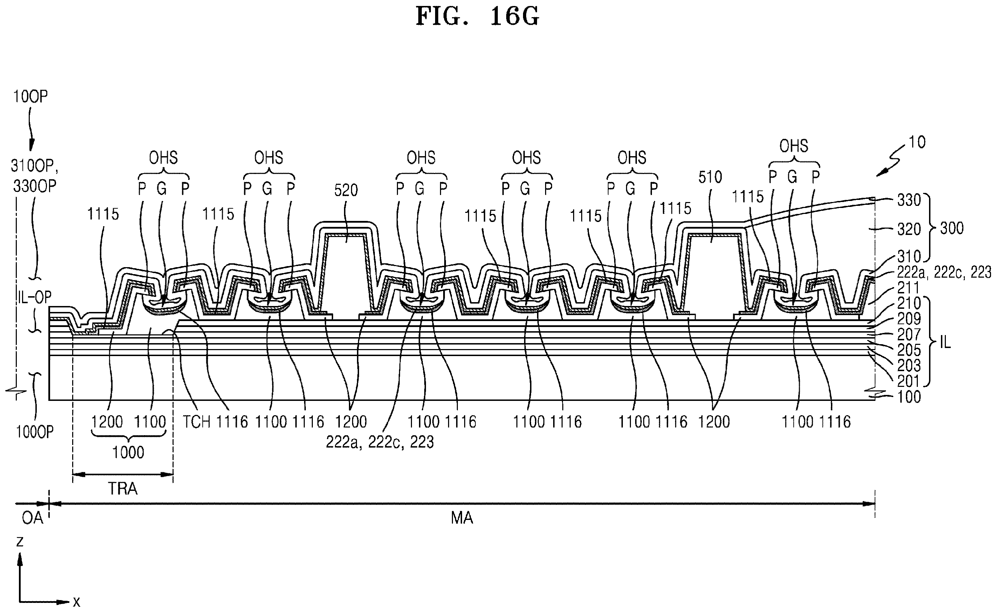

Referring to FIG. 16F, when components located in the opening area OA are removed along a cutting line CL by using a laser beam or the like, the opening 10OP in the display panel 10 may be formed in the opening area OA as illustrated in FIG. 16G.

Cracks may be formed around the opening area OA due to the impact generated during a cutting process to remove the components located in the opening area OA. The crack or impact described above may proceed toward the display area DA, but because the display panel 10 includes a structure of the trench TCH, damage to the display panel 10 caused by the crack or impact described above may be prevented. The structure of the first layer 1100 and the second layer 1200 overlapping the trench TCH may prevent damage to the display panel 10 due to cracks or impact together with the trench TCH described above.

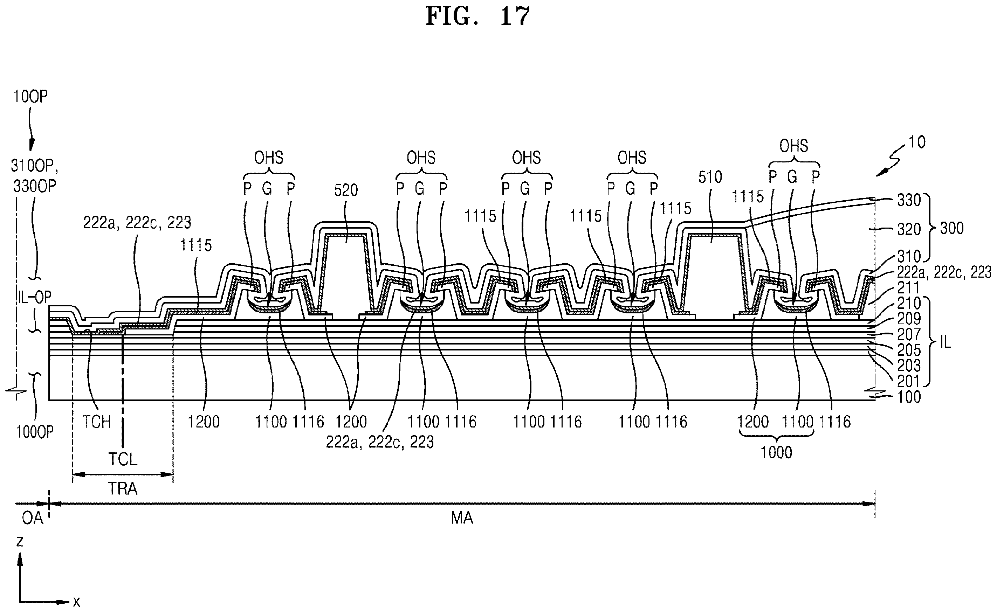

FIG. 17 is a cross-sectional view of a portion of a display panel 10 according to another embodiment.

According to the embodiment described with reference to FIG. 7, the trench TCH and the overhang structure OHS overlapping each other are illustrated, but the present disclosure is not limited thereto. As another embodiment, as illustrated in FIG. 17, the display panel 10 includes the trench TCH, and the trench TCH and the overhang structure OHS do not overlap each other. The second layer 1200 corresponding to the trench TCH and the display area DA (see, e.g., FIG. 5) or corresponding to the overhang structure OHS between the trench TCH and the second partition wall 520 may extend to overlap a portion of the trench TCH.

The trench TCH may have a first edge portion and a second edge portion respectively arranged on opposite sides with respect to the imaginary line TCL passing through the center of the trench TCH in the width direction. The first edge portion (e.g., the left edge portion in FIG. 17) may be relatively adjacent to the opening area OA, and the second edge portion (e.g., the right edge portion in FIG. 17) may be relatively adjacent to the display area DA (see, e.g., FIG. 5) as the opposite side to the first edge portion.

The second layer 1200 extending toward the trench TCH may cover a step, for example, a step formed between the inner surface ILi (see, e.g., FIG. 13) of the inorganic insulation structure IL defining the trench TCH and the upper surface ILu (see, e.g., FIG. 13) of the inorganic insulation structure IL. The second layer 1200 described above may be in direct contact with a portion of the bottom surface of the trench TCH.

The protective layer 1115 on the second layer 1200 may extend toward the trench TCH and may be in direct contact with a portion of the bottom surface of the trench TCH past an end of the second layer 1200.

Respective separated portions of each of the first functional layer 222a, the second functional layer 222c, and the opposite electrode 223, which are separated by the overhang structure OHS closest to the trench TCH, may extend onto the bottom surface of the trench TCH. In an embodiment, the edge of each of the separated portions of the first functional layer 222a, the second functional layer 222c, and the opposite electrode 223 extending to the bottom surface of the trench TCH may be positioned in the trench TCH as illustrated in FIG. 17. In another embodiment, the separated portions of each of the first functional layer 222a, the second functional layer 222c, and the opposite electrode 223 extending to the bottom surface of the trench TCH may extend toward the opening area OA as illustrated in FIG. 7.

An impact or crack applied during the manufacturing process of the opening area OA may be blocked or minimized from progressing toward the display area DA (see, e.g., FIG. 5) by the structure of the trench TCH, and the second layer 1200 and the protective layer 1115, each including a conductive material, may block or reduce the progress of the impact or crack together with the structure of the trench TCH.

The present disclosure has been described with reference to embodiments thereof as illustrated in the drawings, but these are merely examples. Those skilled in the art will understand that various modifications and variations of the embodiments may be made. Therefore, the technical scope of the present disclosure is determined by the scope of the appended claims

In a display panel according to an embodiment, problems such as cracks in a non-display area may be prevented. In the display panel according to an embodiment, exfoliation of inorganic encapsulation layers around an opening area may be prevented. According to the display panel according to embodiments, damage to display elements due to external impurities, such as moisture, due to an opening area may be prevented. However, the aspects and features of the present disclosure described above are examples, and aspects and features of the present disclosure are not limited thereto.

It should be understood that embodiments described herein should be considered in a descriptive sense and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the present disclosure as defined by the appended claims.

## Claims

1. A display panel (10) comprising:
a substrate (100) having an upper surface (100u) and a lower surface opposite to the upper surface (100u) and an opening (100OP) passing from the upper surface (100u) to the lower surface;
an inorganic insulation structure (IL) comprising a plurality of inorganic insulating layers on the upper surface (100u) of the substrate (100);
a plurality of light-emitting diodes (LED) on an upper surface (ILu) of the inorganic insulation structure (IL) and defining a display area (DA) extending around a periphery of the opening (100OP), at least one of the plurality of light-emitting diodes (LED) comprising a pixel electrode (221), an opposite electrode (223) on the pixel electrode (221), and an intermediate layer (222) between the pixel electrode (221) and the opposite electrode (223);
an encapsulation layer (300) on the plurality of light-emitting diodes (LED) and comprising an inorganic encapsulation layer (310, 330) and an organic encapsulation layer (320);
a trench (TCH) in the inorganic insulation structure (IL) and located in a non-display area (PA) between the opening (100OP) in the substrate (100) and the display area (DA);
an insulating layer (1100) on one edge portion of the trench (TCH) and having a groove (G) defined therein; and
a first metal layer (1200) and a second metal layer (1200) spaced apart from each other on the insulating layer (1100),
wherein the first metal layer (1200) has a first overhang portion (P) extending toward the groove (G) from a point at where a lower surface of the first metal layer (1200) and an inner surface (1100i) of the insulating layer (1100) defining the groove (G) meet each other, the first overhang portion (P) overlapping the trench (TCH),
wherein the second metal layer (1200) has a second overhang portion (P) extending toward the groove (G) from a point at where a lower surface of the second metal layer (1200) and the inner surface (1100i) of the insulating layer (1100) defining the groove (G) meet each other, and
wherein an organic layer (222b) of the intermediate layer (222) is separated into a plurality of portions by the first overhang portion (P) and the second overhang portion (P).

2. The display panel (10) of claim 1, wherein the trench (TCH) has a first edge portion adjacent to the opening (100OP) in the substrate (100) and a second edge portion opposite the first edge portion, and
wherein the insulating layer (1100) overlaps the second edge portion.

3. The display panel (10) of claim 1 or 2, wherein
the insulating layer (1100) comprises an organic insulating material; and/or
an upper surface of the first overhang portion (P) is substantially parallel to a virtual plane parallel to the substrate (100) or is tilted downwardly.

4. The display panel (10) of any one of the preceding claims, wherein a portion of the first metal layer (1200) on an opposite side to the first overhang portion (P) is in direct contact with a bottom surface of the trench (TCH), and
wherein a portion of the second metal layer (1200) is in direct contact with the upper surface (ILu) of the inorganic insulation structure (IL).

5. The display panel (10) of any one of the preceding claims, further comprising a protective layer (1115) on the first overhang portion (P) of the first metal layer (1200).

6. The display panel (10) of claim 5, wherein the protective layer (1115) is on an upper surface and a side surface of the first overhang portion (P).

7. The display panel (10) of claim 5 or 6, further comprising a protective material layer (1116) on a bottom surface of the groove, the protective material layer (1116) comprising a same material as the protective layer (1115).

8. The display panel (10) of any one of claims 5 to 7, wherein the protective layer (1115) comprises a same material as the pixel electrode (221).

9. The display panel (10) of any one of claims 5 to 8, wherein the protective layer (1115) extends over a bottom surface of the trench (TCH) and is in direct contact with the bottom surface of the trench (TCH).

10. The display panel (10) of any one of the preceding claims, further comprising a partition wall (510, 520) located in the non-display area (PA) and surrounding the opening (100OP) in the substrate (100),
wherein the partition wall (510, 520) is between the trench (TCH) and the display area (DA).

11. The display panel (10) of claim 10, further comprising:
a first insulating layer (1100) between the trench (TCH) and the display area (DA) and spaced apart from the insulating layer (1100); and
a pair of metal layers (1200) on the first insulating layer (1100), each having an overhang portion (P),
wherein the overhang portion (P) hangs over the groove of the first insulating layer (1100) from a point at where a lower surface of a corresponding metal layer (1200) from among the pair of metal layers (1200) and an inner surface (1100i) of the first insulating layer (1100) defining the groove (G) meet each other.

12. The display panel (10) of claim 11, wherein one of the pair of metal layers (1200) comprises a portion opposite to the overhang portion (P) of the one of the metal layers (1200), and
wherein the portion of the one of the metal layers (1200) overlaps the partition wall (510, 520).

13. The display panel (10) of claim 12, further comprising an additional protective layer (1115) on the overhang portion (P) of the one of the metal layers (1200),
wherein the additional protective layer (1115) extends over an upper surface of the portion of the one of the metal layers (1200) and overlaps the partition wall (510, 520).

14. An electronic apparatus (1) comprising:
a display panel (10) according to any one of the preceding claims, having an opening area (OA) and a display area (DA) extending around a periphery of the opening area (OA); and
a component (70) overlapping the opening area (OA) of the display panel (10).

15. The electronic apparatus (1) of claim 14, wherein the component (70) comprises a camera or a sensor.
